# EUROPÄISCHE PATENTANMELDUNG

(11) **EP 3 916 780 A2**
(43) Veröffentlichungstag der Anmeldung: **01.12.2021**
(21) Anmeldenummer: 21175913.9
(22) Anmeldetag: 26.05.2021
(51) Int. Cl.: H01L 23/66, H01L 21/60, H01L 25/16, H01L 25/03, H05K 1/18, H01L 23/31, H01L 23/498, H01L 23/367, H01L 25/10

(54) **MIKROELEKTRONISCHE ANORDNUNG UND VERFAHREN ZUR HERSTELLUNG DERSELBEN**

(30) Priorität: 29.05.2020 DE 102020206769
(71) Anmelder: FRAUNHOFER-GESELLSCHAFT zur Förderung der angewandten Forschung e.V., 80686 München (DE)
(72) Erfinder: Landesberger, Christof, 80686 München (DE); Kutter, Christoph, 80686 München (DE); Ramm, Peter, 80686 München (DE)
(74) Vertreter: Schlenker, Julian

(57) **Zusammenfassung**

Ausführungsbeispiele schaffen ein Verfahren zur Herstellung einer mikroelektronischen Anordnung. Das Verfahren umfasst einen Schritt des Bereitstellens eines Chip-Folien-Moduls (120) mit einem Halbleiterchip (122) und einem Foliensubstrat (124), auf dem der Halbleiterchip angeordnet ist, wobei das Chip-Folien-Modul zumindest ein von dem Halbleiterchip beabstandetes Kopplungselement (126) aufweist, das mit zumindest einem Anschluss des Halbleiterchips elektrisch gekoppelt ist. Ferner umfasst das Verfahren einen Schritt des Einbettens des Chip-Folien-Moduls in eine Leiterplatte (142), wobei bei dem Einbetten des Chip-Folien-Moduls in die Leiterplatte das zumindest eine Kopplungselement (126) des Chip-Folien-Moduls vertikal [z.B. in vertikaler Richtung [z.B. in Bezug auf die Leiterplatte]] [z.B. senkrecht zu einer Oberfläche der Leiterplatte] mit zumindest einem Kopplungsgegenelement (144) der Leiterplatte gekoppelt wird.

## Beschreibung

Ausführungsbeispiele beziehen sich auf ein Verfahren zur Herstellung einer mikroelektronischen Anordnung, und im speziellen, auf eine mikroelektronische Anordnung mit einem Chip-Folien-Modul (z.B. Chip-Folien-Interposer). Weitere Ausführungsbeispiele beziehen sich auf eine solche mikroelektronische Anordnung. Manche Ausführungsbeispiele beziehen sich auf eine modulare Integration von Chip-Folien-Interposern.

Ein grundsätzliches Ziel der Mikroelektronik ist es, die funktionalen Komponenten immer kleiner, dünner, leichter herzustellen und damit eine zunehmende Nutzung entweder für portable elektronische Geräte (z.B. Smartphone, Laptop, Smart Watch, körpernahe Sensorik) zu ermöglichen oder Rechengeschwindigkeit oder Speicherkapazität zu verbessern bei gleichzeitiger Volumenreduktion des integrierten Systems.

Bekannt ist eine Vielzahl von verschiedenen dreidimensionalen Integrationstechniken. Diese basieren oft auf der Nutzung von leitfähigen Kontaktierungen (z.B. Silizium-Durchkontaktierungen, engl. through silicon via, TSV), die senkrecht durch das Wafer-Substrat führen. Das Substrat kann der Halbleiter-Wafer (z.B. mit den IC-Elementen (IC = Integrated Circuit, dt. integrierter Schaltkreis)) selber sein oder auch ein zusätzlicher sog. Interposer-Wafer aus Silizium oder Glas. Ein Interposer bezeichnet hierbei eine elektrische Schnittstellenführung von einem Anschlussfeld oder einer Verbindung zu einem anderen Anschlussfeld oder einer anderen Verbindung. Der Zweck eines Interposers besteht beispielsweise darin, ein Anschlussfeld auf ein größeres Anschlussfeld zu führen oder eine Verbindung auf eine andere Verbindung umzuleiten. Im Falle von Silizium-Substraten ist die leitfähige Durchkontaktierung (engl. Via) gegen das umgebende Substrat elektrisch isoliert. Die Technologie zur Herstellung dieser Durchkontaktierungen auf Wafer-Substraten ist aufwändig und kann nur in speziellen Halbleiterfabriken ausgeführt werden. Im Falle von Glas-Interposern entfällt zwar die Notwendigkeit der Isolation. Es bleibt jedoch die aufwändige Prozess-Sequenz; außerdem sind die sehr dünnen Glas-Interposer-Wafer sehr bruchgefährdet.

Ein weiterer Nachteil der sog. Wafer-to-Wafer (dt. Wafer zu Wafer) Integrationstechniken ist der Verlust an Ausbeute im dreidimensionalen Stapel, da generell alle Chip-Bausteine auf einem Wafer kontaktiert werden, auch solche die elektrisch nicht funktional sind.

Eine Alternative hierzu ist die sog. Chip-to-Wafer (dt. Chip zu Wafer) Integration, bei der auch schon getestete integrierte Schaltungen (engl. integrated circuits, IC) vorselektiert werden. Substrate in Chip-to-Wafer Konfiguration weisen eine große Topographie auf. Das führt zu dem Nachteil, dass eine aufwändige Planarisierung in jeder Ebene erforderlich ist.

Ein Verfahren zur Herstellung eines Chip-Folien-Interposers ist beispielsweise aus der DE 10 2017 208 435 A1 bekannt.

Ferner sind sog. Embedding Technologien (dt. Einbettungstechniken) bekannt, bei denen ungehäuste Halbleiter-Bausteine (z.B. integrierte Schaltkreise, engl. integrated circuits, IC) in einer Leiterplatte eingebettet werden und mit Techniken der Leiterplatten-Technologie elektrisch kontaktiert werden. Hierbei gibt es eine große Hürde: Die Flächen der Kontakt-Pads auf dem Chip sind so klein, dass sie mit den Strukturierungstechniken der PCB Industrie (PCB = Printed Circuit Board, dt. Leiterplatte) praktisch nicht gezielt und mit der erforderlichen hohen Ausbeute kontaktiert und verdrahtet werden können. Herkömmlicherweise wird deshalb auf den Halbleiter-Wafern zunächst eine Umverdrahtung (z.B. mittels einer Umverdrahtungsebene (engl. redistribution layer, RDL) realisiert, die dem Zweck dient, die üblicherweise nur am Rand eines Chip-Layouts befindlichen sehr kleinen Kontakt-Pads in einer zusätzlichen oberen Metallisierungsebene über die gesamte Chip-Fläche zu verteilen und zudem die Pad-Fläche auf über 200 µm x 200 µm Größe aufzuweiten. Zudem müssen diese umverteilten Kontaktflächen mit einer stabilen Metallisierungsschicht versehen werden, wie z.B. Nickel und Gold mit einer Dicke von einigen µm, da bei der späteren Herstellung von Durchkontaktierungen in der Leiterplattenfabrik ein Laser benutzt wird, um ein Kontaktloch bis auf den Chip-Kontakt hinunter zu öffnen. Der Laser erzeugt im Leiterplattenmaterial üblicherweise ein Loch mit einem Durchmesser der über 100 µm liegt (also größer als die ursprünglichen kleinen Kontakt-Pads auf dem integrierten Schaltkreis (IC)) und beschädigt auch die Metallfläche auf dem Kontakt-Pad. Deshalb muss das Kontakt-Pad größer werden (durch die Umverdrahtung) und stabiler gegen den Laser-Beschuss (deshalb zusätzlich Ni / Au Beschichtung). Beide Prozesse sind aufwändig und kostenrelevant. Weiteres Problem ist die Handhabung von ungehäusten Chips in der Leiterplattenfabrik; üblicherweise sind dort keine Maschinen für die Verarbeitung von sehr kleinen und bruchgefährdeten Halbleiterbauelementen vorhanden.

Gehäuste Bauelemente (z.B. Silizium-Chips in sog. Mold-Packages (dt. gegossenen Gehäusen) mit einer Dicke von ca. 1 mm) in eine Leiterplatte zu integrieren, macht keinen Sinn, da die Leiterplatte dadurch noch dicker werden würde und die geometrische Freiheit bei der Ausführung der Verdrahtung (Layout) eingeschränkt wird; es entsteht also kein Vorteil im Sinne von höherer Integrationsdichte oder kleinerer Bauform.

Bekannt sind ferner mehrlagige Leiterplatten, die in jeder Ebene eine Laminatschicht (z.B. "Prepreg": Epoxidschicht mit Kupferbeschichtung) aufweisen. Üblicherweise werden die Kupferschichten nass-chemisch strukturiert, so dass Leiterbahnen entstehen. Dabei werden lithografische Masken oder digitale Direkt-Lithografie eines Fotolacks eingesetzt.

Der vorliegenden Erfindung liegt somit die Aufgabe zugrunde die bestehende Situation zu verbessern.

Diese Aufgabe wird durch die unabhängigen Patentansprüche gelöst.

Vorteilhafte Weiterbildungen finden sich in den abhängigen Patentansprüchen.

Ausführungsbeispiele schaffen ein Verfahren zur Herstellung einer mikroelektronischen Anordnung. Das Verfahren umfasst einen Schritt des Bereitstellens eines Chip-Folien-Moduls [z.B. Folien-Interposer] mit einem Halbleiterchip und einem Foliensubstrat, auf dem der Halbleiterchip angeordnet ist, wobei das Chip-Folien-Modul zumindest ein von dem Halbleiterchip beabstandetes Kopplungselement aufweist, das mit zumindest einem Anschluss des Halbleiterchips elektrisch gekoppelt ist. Ferner umfasst das Verfahren einen Schritt des Einbettens des Chip-Folien-Moduls in eine Leiterplatte, wobei bei dem Einbetten des Chip-Folien-Moduls in die Leiterplatte das zumindest eine Kopplungselement des Chip-Folien-Moduls vertikal [z.B. in vertikaler Richtung [z.B. in Bezug auf die Leiterplatte]] [z.B. senkrecht zu einer Oberfläche der Leiterplatte] mit zumindest einem Kopplungsgegenelement der Leiterplatte gekoppelt wird.

Der vorliegenden Erfindung liegt die Idee zugrunde, einen (dünnen) Halbleiterchip (z.B. Halbleiter-Baustein) erst in ein ebenfalls dünnes, folienbasiertes Modul (z.B. Gehäuse, engl. package) zu integrieren und dieses Chip-Folien-Modul (z.B. Folien-Interposer) dann in einer Leiterplatte dauerhaft zu integrieren und die jeweiligen (z.B. elektrischen, optischen, kapazitiven, induktiven, elektromagnetischen) Verbindungen zu realisieren.

Bei Ausführungsbeispielen hat das Chip-Folien-Modul (z.B. Chip-Folien-Package oder Folien-Interposer) im Wesentlichen die Funktion, die sehr kleinen Geometrien der Kontakt-Pads auf dem Halbleiterchip (z.B. Fläche der Pads derzeit ca. 60 µm x 60 µm; Abstand der Pads: 20 - 60 µm) über eine Kontaktierung und Umverdrahtung auf dem dünnen Folienträger auf ein Maß aufzuweiten, das mit den typischen Geometrien einer Standard Leiterplattenfertigung kompatibel ist. Das heißt, Pad-Größe und Pad-Abstände der Außenkontakte auf dem Chip-Folien-Modul können dann größer als 100 µm sein, bevorzugt über 200 µm.

Bei Ausführungsbeispielen kann das (dünne) Chip-Folien-Modul (z.B. Folien-Interposer) mit integriertem Halbleiterchip (z.B. Halbleiter-Baustein) dann in einer inneren Lage einer Leiterplatte eingebracht und dauerhaft verbunden werden. Es können ein oder auch mehrere solcher eingebetteter Chip-Folien-Module in einem Leiterplatten-Bauteil enthalten sein, ebenso können die Chip-Folien-Module als dreidimensionaler Stapel in der Leiterplatte integriert werden.

Bei Ausführungsbeispielen ist zumindest ein Kopplungselement des zumindest einen Kopplungselements des Chip-Folien-Moduls ein elektrischer Anschluss, wobei zumindest ein Kopplungsgegenelement des zumindest einen Kopplungsgegenelements der Leiterplatte eine Durchkontaktierung ist.

Bei Ausführungsbeispielen ist eine Anschlussfläche des Anschlusses des Chip-Folien-Moduls [z.B. zumindest um den Faktor 1,5 oder 2] größer als eine Anschlussfläche des Anschlusses des Halbleiterchips, und/oder wobei Abstände zwischen Anschlüssen des Chip-Folien-Moduls [z.B. zumindest um den Faktor 1,5 oder 2] größer sind als Abstände zwischen Anschlüssen des Hableiterchips.

Bei Ausführungsbeispielen ist zumindest ein Kopplungselement des zumindest einen Kopplungselements des Chip-Folien-Moduls ein optisches Kopplungselement [z.B. LED, Fotodiode oder Fotodetektor], wobei zumindest ein Kopplungsgegenelement des zumindest einen Kopplungsgegenelements der Leiterplatte ein optisches Kopplungsgegenelement [z.B. Fotodetektor, Fotodiode oder LED] ist.

Bei Ausführungsbeispielen ist zumindest ein Kopplungselement des zumindest einen Kopplungselements des Chip-Folien-Moduls ein induktives oder kapazitives Kopplungselement [z.B. Spule/Leiterschleife oder Kondensatorplatte], wobei zumindest ein Kopplungsgegenelement des zumindest einen Kopplungsgegenelements der Leiterplatte ein induktives oder kapazitives Kopplungsgegenelement [z.B. Spule/Leiterschleife oder Kondensatorplatte] ist.

Bei Ausführungsbeispielen ist der Halbleiterchip in dem Chip-Folien-Modul [z.B. vollständig] eingebettet [z.B. durch eine Einbettungsschicht und das Foliensubstrat].

Bei Ausführungsbeispielen ist das zumindest eine Kopplungselement auf oder in dem Foliensubstrat angeordnet und über zumindest eine auf oder in dem Foliensubstrat gebildete Leiterbahn mit dem zumindest einen Anschluss des Halbleiterchips verbunden.

Bei Ausführungsbeispielen ist der Halbleiterchip derart auf dem Foliensubstrat angeordnet, dass der zumindest eine Anschluss des Halbleiterchips dem Foliensubstrat abgewandt ist, wobei das zumindest eine Kopplungselement in oder auf einer Einbettungsschicht des Chip-Folien-Moduls angeordnet ist, in der der Halbleiterchip eingebettet ist, wobei das zumindest eine Kopplungselement über eine vertikale elektrische Verbindung mit dem zumindest einen Anschluss des Halbleiterchips verbunden ist.

Bei Ausführungsbeispielen weist das Foliensubstrat zumindest zwei Anschlusselemente auf, die über zumindest zwei in auf der dem Foliensubstrat gebildeten Leiterbahnen mit zumindest zwei Anschlüssen des Halbleiterchips verbunden sind, wobei das Chip-Folien-Modul zumindest zwei übereinander liegende oder gestapelte Einbettungsschichten aufweist, die den Halbleiterchip und/oder das Foliensubstrat einbetten, wobei das Chip-Folien-Modul zumindest zwei Kopplungselemente aufweist, die in oder auf unterschiedlichen Einbettungsschichten der zumindest zwei Einbettungsschichten angeordnet sind, wobei die zumindest zwei Kopplungselemente über vertikale elektrische Verbindungen mit den zumindest zwei Anschlusselementen des Foliensubstrats verbunden sind.

Bei Ausführungsbeispielen weist die Leiterplatte zumindest zwei Laminatebenen auf, in der das Chip-Folien-Modul [z.B. vollständig] eingebettet ist.

Bei Ausführungsbeispielen ist der Halbleiterchip über das zumindest eine Kopplungselement des Chip-Folien-Moduls und das zumindest eine Kopplungsgegenelement der Leiterplatte mit zumindest einer Schaltungskomponente der Leiterplatte verbunden.

Bei Ausführungsbeispielen weist der Schritt des Bereitstellens des Chip-Folien-Moduls auf:
- Bereitstellen des Halbleiterchips,
- Bereitstellen des Foliensubstrats,
- Verbinden des Halbleiterchips mit dem Foliensubstrat.

Bei Ausführungsbeispielen weist der Schritt des Bereitstellens des Chip-Folien-Moduls ferner auf:
- Einbetten des Halbleiterchips in eine Einbettungsschicht.

Bei Ausführungsbeispielen weist der Schritt des Einbettens des Chip-Folien-Moduls in die Leiterplatte auf:
- Bereitstellen zumindest einer Laminatebene der Leiterplatte,
- Anordnen des Chip-Folien-Moduls auf der zumindest einen Laminatebene der Leiterplatte oder innerhalb der zumindest einen Laminatebene der Leiterplatte,
- Bereitstellen zumindest einer weiteren Laminatebene der Leiterplatte auf und/oder unter der zumindest einen Laminatebene der Leiterplatte, so dass das Chip-Folien-Modul in der Leiterplatte eingebettet ist.

Bei Ausführungsbeispielen weist das Foliensubstrat zumindest zwei von dem Halbleiterchip beabstandetes Kopplungselemente auf, die über zwei in oder auf dem Foliensubstrat gebildete Leiterbahnen mit zumindest zwei Anschlüssen des Halbleiterchips verbunden sind, wobei die zumindest zwei Kopplungselemente elektrische Anschlüsse sind, wobei Leiterbahnen der Leiterplatte über zumindest zwei Durchkontaktierungen als Gegenkopplungselemente mit den Anschlüssen des Foliensubstrats verbunden sind.

Bei Ausführungsbeispielen ist der Halbleiterchip in dem Chip-Folien-Modul in einer Einbettungsschicht, die auf dem Foliensubstrat angeordnet ist, eingebettet.

Bei Ausführungsbeispielen erstrecken sich die zumindest zwei Durchkontaktierungen vertikal durch das Foliensubstrat oder durch die Einbettungsschicht hindurch bis zu den zumindest zwei Anschlüssen des Foliensubstrats.

Bei Ausführungsbeispielen erstreckt sich eine erste Durchkontaktierung der zumindest zwei Durchkontaktierungen ausgehend von einer ersten Ebene der Leiterplatte vertikal durch das Foliensubstrat hindurch bis zu einem ersten Anschluss der zumindest zwei Anschlüsse des Foliensubstrats, und/oder wobei sich eine zweite Durchkontaktierung der zumindest zwei Durchkontaktierungen ausgehend von einer zweiten Ebene der Leiterplatte vertikal durch die Einbettungsschicht des Chip-Folien-Moduls hindurch bis zu einem zweiten der zumindest zwei Anschlüsse des Foliensubstrats erstreckt.

Bei Ausführungsbeispielen ist das zumindest eine Kopplungselement auf oder in dem Foliensubstrat angeordnet und über zumindest eine auf oder in dem Foliensubstrat gebildete Leiterbahn mit dem zumindest einen Anschluss des Halbleiterchips verbunden, wobei zumindest ein Kopplungselement des zumindest einen Kopplungselements des Folien-Schnittstellensubstrats ein optisches Kopplungselement ist, wobei zumindest ein Kopplungsgegenelement des zumindest einen Kopplungsgegenelements der Leiterplatte ein optisches Kopplungsgegenelement ist, wobei das optische Kopplungselement und das optische Gegenkopplungselement in vertikaler Richtung miteinander optisch gekoppelt sind.

Bei Ausführungsbeispielen ist zumindest ein weiteres Kopplungselement des zumindest einen Kopplungselements auf oder in dem Foliensubstrat angeordnet ist und über zumindest eine weitere auf oder in dem Foliensubstrat gebildete Leiterbahn mit zumindest einem weiteren Anschluss des Halbleiterchips verbunden, wobei das zumindest eine weitere Kopplungselement ein induktives oder kapazitives Kopplungselement ist, wobei zumindest ein weiteres Kopplungsgegenelement des zumindest einen Kopplungsgegenelements der Leiterplatte ein induktives oder kapazitives Kopplungsgegenelement ist, wobei das induktive oder kapazitive Kopplungselement und das induktive oder kapazitive Kopplungsgegenelement in vertikaler Richtung miteinander induktiv oder kapazitiv gekoppelt sind.

Bei Ausführungsbeispielen weist das Chip-Folien-Modul zumindest zwei Kopplungselemente auf, wobei der Halbleiterchip zumindest zwei Anschlüsse aufweist, wobei der Halbleiterchip derart auf dem Foliensubstrat angeordnet ist, dass die zumindest zwei Anschlüsse des Halbleiterchips dem Foliensubstrat abgewandt sind, wobei die zumindest zwei Kopplungselemente in oder auf einer Einbettungsschicht des Chip-Folien-Moduls angeordnet sind, in der der Halbleiterchip eingebettet ist, wobei die zumindest zwei Kopplungselemente über vertikale elektrische Verbindungen mit dem zumindest zwei Anschlüssen des Halbleiterchips verbunden sind, wobei die zumindest zwei Kopplungselemente elektrische Anschlüsse sind, wobei Leiterbahnen der Leiterplatte über zumindest zwei Durchkontaktierungen als Gegenkopplungselemente mit den zumindest zwei Anschlüssen des Chip-Folien-Moduls verbunden sind.

Bei Ausführungsbeispielen ist das Foliensubstrat ein thermisch leitfähiges Foliensubstrat, wobei die Leiterplatte benachbart zu dem thermisch leitfähigen Foliensubstrat thermische Durchkontaktierung aufweist, die ausgebildet sind, um thermische Energie von dem thermisch leitfähigen Foliensubstrat an eine Umgebung der Leiterplatte zu leiten.

Bei Ausführungsbeispielen weist das Foliensubstrat zumindest zwei Anschlusselemente auf, die über zumindest zwei in auf der dem Foliensubstrat gebildeten Leiterbahnen mit zumindest zwei Anschlüssen des Halbleiterchips verbunden sind, wobei das Chip-Folien-Modul zumindest zwei übereinander liegende oder gestapelte Einbettungsschichten aufweist, die den Halbleiterchip und/oder das Foliensubstrat einbetten, wobei das Chip-Folien-Modul zumindest zwei Kopplungselemente aufweist, die in oder auf unterschiedlichen Einbettungsschichten der zumindest zwei Einbettungsschichten angeordnet sind, wobei die zumindest zwei Kopplungselemente über vertikale elektrische Verbindungen mit den zumindest zwei Anschlusselementen des Foliensubstrats verbunden sind, wobei die zumindest zwei Kopplungselemente elektrische Anschlüsse sind, wobei Leiterbahnen der Leiterplatte über zumindest zwei Durchkontaktierungen als Gegenkopplungselemente mit den zumindest zwei Anschlüssen des Chip-Folien-Moduls verbunden sind, wobei sich eine erste Durchkontaktierung der zumindest zwei Durchkontaktierungen ausgehend von einer ersten Ebene der Leiterplatte vertikal bis zu einem ersten Anschluss der zumindest zwei Anschlüsse des Chip-Folien-Moduls erstreckt, wobei sich eine zweite Durchkontaktierung der zumindest zwei Durchkontaktierungen ausgehend von einer zweiten Ebene der Leiterplatte vertikal bis zu einem zweiten der zumindest zwei Anschlüsse des Foliensubstrats erstreckt.

Bei Ausführungsbeispielen weist das Verfahren einen Schritt des Bereitstellens eines weiteren Chip-Folien-Moduls [z.B. Folien-Interposer] mit einem weiteren Halbleiterchip und einem weiteren Foliensubstrat, auf dem der weitere Halbleiterchip angeordnet ist, auf, wobei das weitere Chip-Folien-Modul zumindest ein von dem weiteren Halbleiterchip beabstandetes Kopplungselement aufweist, das mit zumindest einem Anschluss des weiteres Halbleiterchips elektrisch gekoppelt ist, und wobei das Verfahren einen Schritt des Einbettens des weiteren Chip-Folien-Moduls in die Leiterplatte aufweist, wobei bei dem Einbetten des weiteren Chip-Folien-Moduls in die Leiterplatte das zumindest eine Kopplungselement des weiteren Chip-Folien-Moduls vertikal mit zumindest einem weiteren Kopplungsgegenelement der Leiterplatte gekoppelt wird, wobei das Chip-Folien-Modul und das weitere Chip-Folien-Modul in vertikaler Richtung der Leiterplatte gestapelt sind.

Bei Ausführungsbeispielen weist die Leiterplatte zumindest zwei Leiterbahnebenen auf, wobei das Chip-Folien-Modul zwischen den zumindest zwei Leiterbahnebenen angeordnet ist, wobei bei dem Einbetten des Chip-Folien-Moduls in die Leiterplatte eine vertikale Durchkontaktierung durch das Chip-Folien-Modul hindurch zum Verbinden von Leiterbahnen der zumindest zwei Leiterbahnebenen gebildet wird.

Weitere Ausführungsbeispiele schaffen eine mikroelektronische Anordnung mit einer Leiterplatte und einem Chip-Folien-Modul, wobei das Chip-Folien-Modul einen Halbleiterchip und ein Foliensubstrat, auf dem der Halbleiterchip angeordnet ist, aufweist, wobei das Chip-Folien-Modul zumindest ein von dem Halbleiterchip beabstandetes Kopplungselement aufweist, das mit zumindest einem Anschluss des Halbleiterchips elektrisch gekoppelt ist, wobei das Chip-Folien-Modul in die Leiterplatte [z.B. vollständig] eingebettet ist, wobei das zumindest eine Kopplungselement des Chip-Folien-Moduls vertikal [z.B. in vertikaler Richtung [z.B. in Bezug auf die Leiterplatte]] [z.B. senkrecht zu einer Oberfläche der Leiterplatte] mit zumindest einem Kopplungsgegenelement der Leiterplatte gekoppelt ist.

Weitere Ausführungsbeispiele schaffen ein Chip-Folien-Modul mit einem Foliensubstrat, einem Halbleiterchip, der auf dem Foliensubstrat angeordnet ist, und zumindest einem von dem Halbleiterchip beabstandetes Kopplungselement, das auf oder in dem Foliensubstrat angeordnet ist, wobei das zumindest eine Kopplungselement über zumindest eine auf oder in dem Foliensubstrat gebildeten Leiterbahn mit zumindest einem Anschluss des Halbleiterchips elektrisch gekoppelt ist, wobei das zumindest eine Kopplungselement konfiguriert ist, um mit zumindest einem externen Gegenkopplungselement gekoppelt zu werden, wobei das Chip-Folien-Modul eine Einbettungsschicht aufweist, die auf dem Foliensubstrat angeordnet ist, wobei die Einbettungsschicht den Halbleiterchip und das zumindest eine Kopplungselement vollständig einbettet, wobei das zumindest eine Kopplungselement ein elektrischer Anschluss [z.B. ein elektrisches Anschlussfeld [z.B. ein PAD]] ist.

Weitere Ausführungsbeispiele schaffen ein Chip-Folien-Modul mit einem Foliensubstrat, einem Halbleiterchip, der auf dem Foliensubstrat angeordnet ist, und zumindest einem von dem Halbleiterchip beabstandetes Kopplungselement, das auf oder in dem Foliensubstrat angeordnet ist, wobei das zumindest eine Kopplungselement über zumindest eine auf oder in dem Foliensubstrat gebildeten Leiterbahn mit zumindest einem Anschluss des Halbleiterchips elektrisch gekoppelt ist, wobei das zumindest eine Kopplungselement konfiguriert ist, um mit zumindest einem externen Gegenkopplungselement gekoppelt zu werden, wobei das Chip-Folien-Modul eine Einbettungsschicht aufweist, die auf dem Foliensubstrat angeordnet ist, wobei die Einbettungsschicht den Halbleiterchip und das zumindest eine Kopplungselement vollständig einbettet, wobei das zumindest eine Kopplungselement ein optisches Kopplungselement ist.

Weitere Ausführungsbeispiele schaffen ein Chip-Folien-Modul mit einem Foliensubstrat, einem Halbleiterchip, der auf dem Foliensubstrat angeordnet ist, zumindest zwei von dem Halbleiterchip beabstandete Kopplungselemente, wobei das Foliensubstrat zumindest zwei Anschlusselemente aufweist, die über zumindest zwei in auf der dem Foliensubstrat gebildeten Leiterbahnen mit zumindest zwei Anschlüssen des Halbleiterchips verbunden sind, wobei das Chip-Folien-Modul zumindest zwei übereinander liegende oder gestapelte Einbettungsschichten aufweist, die den Halbleiterchip und/oder das Foliensubstrat einbetten, wobei die zumindest zwei Kopplungselemente in oder auf unterschiedlichen Einbettungsschichten der zumindest zwei Einbettungsschichten angeordnet sind, wobei die zumindest zwei Kopplungselemente über vertikale elektrische Verbindungen mit den zumindest zwei Anschlusselementen des Foliensubstrats verbunden sind, wobei die zumindest zwei Kopplungselement konfiguriert sind, um mit zumindest zwei externen Gegenkopplungselementen gekoppelt zu werden.

Weitere Ausführungsbeispiele schaffen eine mikroelektronische Anordnung mit einer Leiterplatte, und einem Chip-Folien-Modul gem. einem der hierin beschriebenen Ausführungsbeispiele, wobei das Chip-Folien-Modul in die Leiterplatte [z.B. vollständig] eingebettet ist, wobei das zumindest eine Kopplungselement des Chip-Folien-Moduls vertikal [z.B. in vertikaler Richtung [z.B. in Bezug auf die Leiterplatte]] [z.B. senkrecht zu einer Oberfläche der Leiterplatte] mit zumindest einem Kopplungsgegenelement der Leiterplatte gekoppelt ist.

Weitere Ausführungsbeispiele schaffen ein Verfahren zur Herstellung von dreidimensionalen elektronischen Systemen, und insbesondere von dreidimensionalen integrierten Schaltungen. Unter einer dreidimensionalen Integration wird die vertikale Verbindung (mechanisch und elektrisch) von Bauelementen verstanden. Die Vorteile eines dreidimensional integrierten elektronischen Systems sind u. a. die erreichbaren höheren Packungsdichten und Schaltgeschwindigkeiten (bedingt durch kürzere Leitungswege) gegenüber zweidimensionalen Systemen (Planartechnik).

Weitere Ausführungsbeispiele schaffen einen mehrlagigen Schaltungsträger, der im Inneren oder an einer Oberfläche einen Folien-Interposer aufweist, dadurch gekennzeichnet, dass auf dem Folien-Interposer Leiterbahnstrukturen ausgeführt sind, die eine elektrische (galvanisch gekoppelte) oder elektro-magnetische oder optische Kopplung zwischen den Leiterbahnstrukturen des Schaltungsträgers und den leitfähigen Strukturen des Folien-Interposers aufweist.

Weitere Ausführungsbeispiele schaffen einen mehrlagigen Schaltungsträger, der im Inneren oder an einer Oberfläche einen Folien-Interposer aufweist, dadurch gekennzeichnet, dass auf dem Folien-Interposer mindestens eine elektrisch funktionale Komponente, z.B. IC-Baustein (IC = Integrated Circuit, dt. integrierter Schaltkreis), angebracht ist.

Weitere Ausführungsbeispiele schaffen einen mehrlagigen Schaltungsträger, der im Inneren oder an einer Oberfläche einen Folien-Interposer aufweist, dadurch gekennzeichnet, dass auf dem Folien-Interposer mindestens eine elektrisch funktionale Komponente, z. B. IC-Baustein (IC = Integrated Circuit, dt. integrierter Schaltkreis), angebracht ist, wobei der Halbleiter-Baustein mit den Leiterbahnen des Schaltungsträgers in elektrischer Verbindung steht.

Weitere Ausführungsbeispiele schaffen einen Folien-Interposer in einem Schaltungsträger, der ein Kontakt-Loch (Durchkontaktierung, engl. via) durch den Folien-Interposer aufweist, wobei kein elektrischer Kontakt zu den Leiterbahnstrukturen des Folien-Interposer vorhanden ist, die Durchkontaktierung aber für die Verdrahtung auf dem Schaltungsträger genutzt werden kann.

Weitere Ausführungsbeispiele schaffen einen Folien-Interposer auf der Basis einer thermisch leitenden Folie, z.B. Kupfer-Folie, die einen formschlüssigen Kontakt zu einer thermisch leitfähigen Schicht im Mehrlagen-Schaltungsträger aufweist.

Weitere Ausführungsbeispiele schaffen einen Schaltungsträger, der eine Mehrzahl von Folien-Interposern aufweist, wobei diese auch in vertikaler Richtung übereinander liegen (dreidimensionaler Stapel von Folien-Interposern in einer Leiterplatte (PCB)) und die Leiterbahnen untereinander in elektrischer Verbindung stehen.

Ausführungsbeispiele der vorliegenden Erfindung werden bezugnehmend auf die beiliegenden Figuren näher beschrieben. Es zeigen:
- Fig. 1: ein Flussdiagramm eines Verfahrens zur Herstellung einer mikroelektronischen Anordnung, gemäß einem Ausführungsbeispiel der vorliegenden Erfindung,
- Fig. 2a: eine schematische Querschnittansicht eines Chip-Folien-Moduls nach dem Schritt des Bereitstellens des Chip-Folien-Moduls, gem. einem Ausführungsbeispiel der vorliegenden Erfindung,
- Fig. 2b: eine schematische Querschnittansicht eines Chip-Folien-Moduls nach dem Schritt des Bereitstellens des Chip-Folien-Moduls, gem. einem weiteren Ausführungsbeispiel der vorliegenden Erfindung,
- Fig. 2c: eine schematische Querschnittansicht der mikroelektronischen Anordnung nach dem Einbetten des Chip-Folien-Moduls in eine Leiterplatte, gemäß einem Ausführungsbeispiel der vorliegenden Erfindung,
- Fig. 3: eine schematische Querschnittansicht eines Chip-Folien-Moduls, gemäß einem ersten Ausführungsbeispiel,
- Fig. 4: eine schematische Querschnittansicht eines Chip-Folien-Moduls, gemäß einem zweiten Ausführungsbeispiel,
- Fig. 5: eine schematische Querschnittansicht eines Chip-Folien-Moduls, gemäß einem dritten Ausführungsbeispiel,
- Fig. 6: eine schematische Querschnittansicht eines Chip-Folien-Moduls, gemäß einem vierten Ausführungsbeispiel,
- Fig. 7: eine schematische Querschnittansicht eines Chip-Folien-Moduls, gemäß einem fünften Ausführungsbeispiel,
- Fig. 8: eine schematische Querschnittansicht eines Chip-Folien-Moduls, gemäß einem sechsten Ausführungsbeispiel,
- Fig. 9: eine schematische Querschnittansicht eines Chip-Folien-Moduls, gemäß einem siebten Ausführungsbeispiel,
- Fig. 10a,b: schematische Querschnittsansichten einer mikroelektronischen Anordnung mit einer Leiterplatte und dem in die Leiterplatte eingebetteten Chip-Folien-Modul aus Fig. 3, gemäß einem ersten Ausführungsbeispiel,
- Fig. 11: eine schematische Querschnittsansicht einer mikroelektronischen Anordnung mit einer Leiterplatte und dem in die Leiterplatte eingebetteten Chip-Folien-Modul aus Fig. 4, gemäß einem zweiten Ausführungsbeispiel,
- Fig. 12: eine schematische Querschnittsansicht einer mikroelektronischen Anordnung mit einer Leiterplatte und dem in die Leiterplatte eingebetteten Chip-Folien-Modul aus Fig. 5, gemäß einem dritten Ausführungsbeispiel,
- Fig. 13: eine schematische Querschnittsansicht einer mikroelektronischen Anordnung mit einer Leiterplatte und dem in die Leiterplatte eingebetteten Chip-Folien-Modul aus Fig. 6, gemäß einem vierten Ausführungsbeispiel,
- Fig. 14: eine schematische Querschnittsansicht einer mikroelektronischen Anordnung mit einer Leiterplatte und dem in die Leiterplatte eingebetteten Chip-Folien-Modul aus Fig. 7, gemäß einem fünften Ausführungsbeispiel,
- Fig. 15a,b: schematische Querschnittsansichten einer mikroelektronischen Anordnung mit einer Leiterplatte und dem in die Leiterplatte eingebetteten Chip-Folien-Modul aus Fig. 8, gemäß einem sechsten Ausführungsbeispiel,
- Fig. 16: eine schematische Querschnittsansicht einer mikroelektronischen Anordnung mit einer Leiterplatte und einem beliebigen in die Leiterplatte eingebetteten Chip-Folien-Modul, gemäß einem siebten Ausführungsbeispiel,
- Fig. 17: eine schematische Querschnittsansicht einer mikroelektronischen Anordnung mit einer Leiterplatte und zwei beliebigen in die Leiterplatte eingebetteten Chip-Folien-Modulen, gemäß einem achten Ausführungsbeispiel, und
- Fig. 18: eine schematische Querschnittsansicht einer mikroelektronischen Anordnung mit einer Leiterplatte und dem in die Leiterplatte eingebetteten Chip-Folien-Modul aus Fig. 9, gemäß einem neunten Ausführungsbeispiel.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

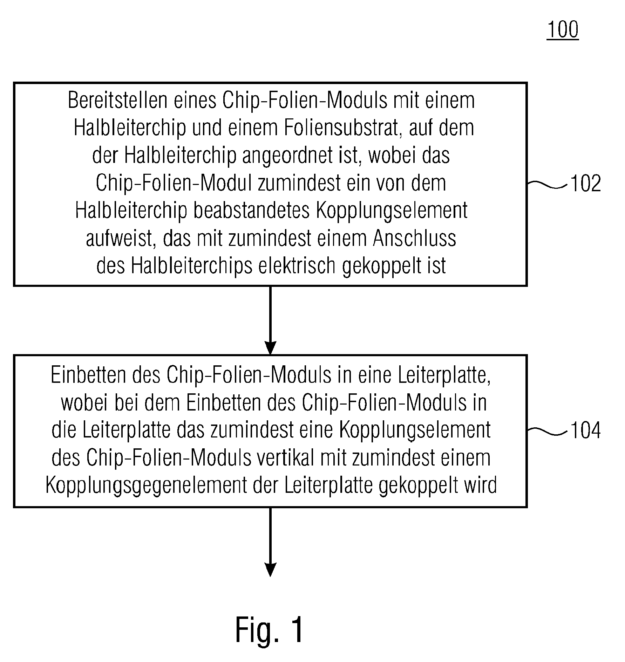

Fig. 1 zeigt ein Flussdiagramm eines Verfahrens 100 zur Herstellung einer mikroelektronischen Anordnung, gemäß einem Ausführungsbeispiel der vorliegenden Erfindung. Das Verfahren 100 umfasst einen Schritt 102 des Bereitstellens eines Chip-Folien-Moduls mit einem Halbleiterchip und einem Foliensubstrat, auf dem der Halbleiterchip angeordnet ist, wobei das Chip-Folien-Modul zumindest ein von dem Halbleiterchip beabstandetes Kopplungselement aufweist, das mit zumindest einem Anschluss des Halbleiterchips elektrisch gekoppelt ist. Das Verfahren 100 umfasst ferner einen Schritt 104 des Einbettens des Chip-Folien-Moduls in eine Leiterplatte, wobei bei dem Einbetten des Chip-Folien-Moduls in die Leiterplatte das zumindest eine Kopplungselement des Chip-Folien-Moduls vertikal mit zumindest einem Kopplungsgegenelement der Leiterplatte gekoppelt wird.

Bei Ausführungsbeispielen kann das Chip-Folien-Modul ein Folien-Interposer sein. Ein Interposer bezieht sich im Allgemeinen auf eine elektrische Schnittstellenführung von zumindest einem Anschlussfeld, z.B. für einen Anschluss des Halbleiterchips, zu zumindest einem anderen Anschlussfeld oder Verbindungselement. Bei Ausführungsbeispielen bezieht sich ein Interposer auf eine elektrische Schnittstellenführung von zumindest einem Anschlussfeld, z.B. für einen Anschluss des Halbleiterchips, zu zumindest einem Kopplungselement (z.B. elektrischen, optischen, induktiven, kapazitiven oder elektromagnetischen Kopplungselement) als Verbindungselement, welches über ein entsprechendes Gegenkopplungselement eine Ankopplung des Kopplungselements und letztendlich des zumindest einem Anschluss des Halbleiterchips ermöglicht.

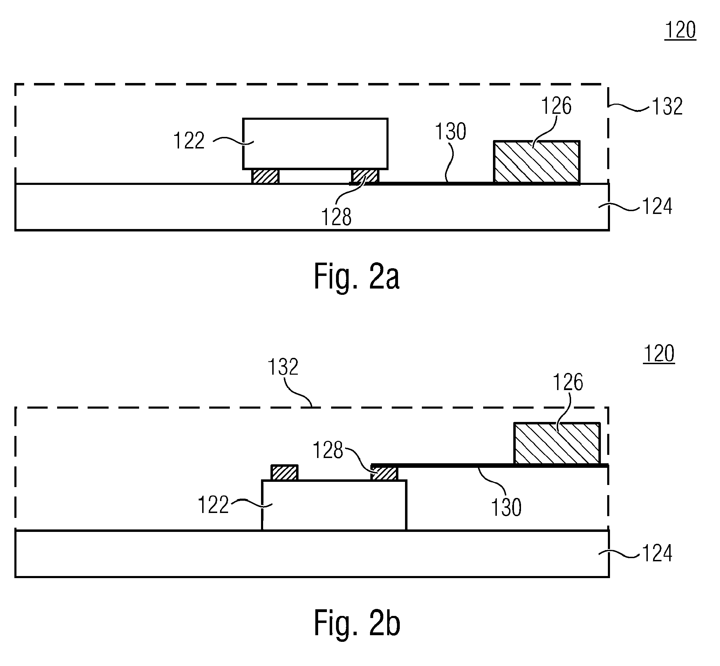

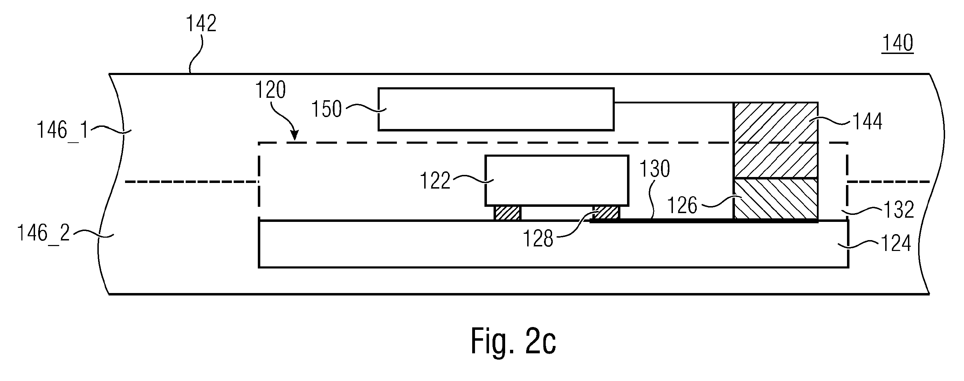

Im Folgenden werden bevorzugte Ausführungsbeispiele des in Fig. 1 gezeigten Verfahrens 100 anhand der Fig. 2a, 2b und 2c näher beschrieben, die schematische Querschnittsansichten des Chip-Folien-Moduls oder der mikroelektronischen Anordnung mit dem in die die Leiterplatte integrierten Chip-Folien-Moduls nach unterschiedlichen Schritten des Verfahrens 100 zeigen.

Fig. 2a zeigt eine schematische Querschnittansicht eines Chip-Folien-Moduls 120 nach dem Schritt 102 des Bereitstellens des Chip-Folien-Moduls 120, gem. einem Ausführungsbeispiel der vorliegenden Erfindung. Wie in Fig. 2a zu erkennen ist, kann das Chip-Folien-Modul 120 einen Halbleiterchip 122 und ein Foliensubstrat 124 aufweisen, wobei der Halbleiterchip 122 auf dem Foliensubstrat 124 angeordnet ist, wobei das Chip-Folien-Modul 120 zumindest ein von dem Halbleiterchip 122 beabstandetes Kopplungselement 126 aufweist, das mit zumindest einem Anschluss 128 des Halbleiterchips 122 elektrisch gekoppelt ist.

Wie in Fig. 2a ferner zu erkennen ist, kann der Halbleiterchip 122 optional in dem Chip-Folien-Modul 120 (z.B. vollständig) eingebettet ist, wie z.B. durch eine Einbettungsschicht 132 und das Foliensubstrat 124.

Bei dem in Fig. 2a gezeigten Ausführungsbeispiel wird beispielhaft davon ausgegangen, dass das zumindest eine Kopplungselement 126 auf oder in dem Foliensubstrat 124 angeordnet ist und über zumindest eine auf oder in dem Foliensubstrat 124 gebildete Leiterbahn 130 mit dem zumindest einen Anschluss 128 des Halbleiterchips 122 verbunden ist.

Fig. 2b zeigt eine schematische Querschnittansicht eines Chip-Folien-Moduls 120 nach dem Schritt 102 des Bereitstellens des Chip-Folien-Moduls 120, gem. einem weiteren Ausführungsbeispiel der vorliegenden Erfindung. Im Unterschied zu dem in Fig. 2a gezeigten Ausführungsbeispiel wird in dem in Fig. 2b gezeigten Ausführungsbeispiel davon ausgegangen, dass der Halbleiterchip 122 derart auf dem Foliensubstrat 124 angeordnet ist, dass der zumindest eine Anschluss 128 des Halbleiterchips dem Foliensubstrat 124 abgewandt ist, wobei das zumindest eine Kopplungselement 126 in oder auf einer Einbettungsschicht 132 des Chip-Folien-Moduls 120 angeordnet ist, in der der Halbleiterchip 122 eingebettet ist, wobei das zumindest eine Kopplungselement über eine elektrische Verbindung 130 mit dem zumindest einen Anschluss des Halbleiterchips verbunden ist.

Bei Ausführungsbeispielen kann das in den Fig. 2a und 2b gezeigte Chip-Folien-Modul durch folgende Schritte hergestellt werden:
- Bereitstellen des Halbleiterchips 122,
- Bereitstellen des Foliensubstrats 124,
- Verbinden des Halbleiterchips 122 mit dem Foliensubstrat 124, und optional
- Einbetten des Halbleiterchips 122 in die Einbettungsschicht 132.

Fig. 2c zeigt eine schematische Querschnittansicht der mikroelektronischen Anordnung 140 nach dem Einbetten des Chip-Folien-Moduls 120 in eine Leiterplatte 142. Wie in Fig. 2c zu erkennen ist, kann bei dem Einbetten des Chip-Folien-Moduls 120 in die Leiterplatte 142 das zumindest eine Kopplungselement 126 des Chip-Folien-Moduls 120 vertikal mit zumindest einem Kopplungsgegenelement 144 der Leiterplatte 142 gekoppelt werden. Der Halbleiterchip 122 kann hierbei über das zumindest eine Kopplungselement 132 des Chip-Folien-Moduls 120 und das zumindest eine Kopplungsgegenelement 144 der Leiterplatte 142 mit zumindest einer Schaltungskomponente 150 der Leiterplatte 142 verbunden sein.

Beispielsweise kann das zumindest eine Kopplungselement 126 des Chip-Folien-Moduls 120 ein elektrischer Anschluss sein, wobei zumindest ein Kopplungsgegenelement 144 der Leiterplatte 142 eine Durchkontaktierung sein kann. Beispielsweise kann eine Anschlussfläche des elektrischen Anschlusses 126 des Chip-Folien-Moduls 120 (z.B. zumindest um den Faktor 1,5 oder 2) größer sein als eine Anschlussfläche des Anschlusses 128 des Halbleiterchips, und/oder wobei Abstände zwischen Anschlüssen 126 des Chip-Folien-Moduls (z.B. zumindest um den Faktor 1,5 oder 2) größer sein können als Abstände zwischen Anschlüssen 128 des Hableiterchips 122.

Beispielsweise kann das zumindest eine Kopplungselement 126 des Chip-Folien-Moduls 120 ein optisches Kopplungselement sein, wie z.B. eine LED, eine Fotodiode oder ein Fotodetektor, wobei das zumindest eine Kopplungsgegenelement 144 der Leiterplatte 142 ein optisches Kopplungsgegenelement sein kann, wie z.B. ein Fotodetektor, eine Fotodiode oder eine LED.

Beispielsweise kann das zumindest eine Kopplungselement 126 des Chip-Folien-Moduls 120 ein induktives oder kapazitives Kopplungselement sein, wie z.B. eine Spule oder Leiterschleife oder eine Kondensatorplatte, wobei das zumindest eine Kopplungsgegenelement 144 der Leiterplatte 142 ein induktives oder kapazitives Kopplungsgegenelement sein kann, wie z.B. eine Spule oder Leiterschleife oder eine Kondensatorplatte.

Bei Ausführungsbeispielen kann die Leiterplatte 142, wie dies in Fig. 2c beispielhalft gezeigt ist, optional zumindest zwei Laminatebenen 146_1 und 146_2 aufweisen, in der das Chip-Folien-Modul 120 (z.B. vollständig) eingebettet ist.

Bei Ausführungsbeispielen kann das Chip-Folien-Modul 120 in die Leiterplatte 142 durch folgende Schritte eingebettet werden:
- Bereitstellen zumindest einer Laminatebene 146_2 der Leiterplatte 142,
- Anordnen des Chip-Folien-Moduls 120 auf der zumindest einen Laminatebene 146_2 der Leiterplatte 142 oder innerhalb der zumindest einen Laminatebene 146_2 der Leiterplatte 142, und
- Bereitstellen zumindest einer weiteren Laminatebene 146_1 der Leiterplatte 142 auf und/oder unter der zumindest einen Laminatebene 146_2 der Leiterplatte 142, so dass das Chip-Folien-Modul 120 in der Leiterplatte 142 eingebettet ist.

Bei Ausführungsbeispielen kann der Halbleiterchip 122 (z.B. Halbleiterbaustein) eine Dicke von 10 - 250 µm, bevorzugt von 20 bis 100 µm, aufweisen.

Bei Ausführungsbeispielen kann das Foliensubstrat 124 eine Dicke (Foliendicke) von 10 bis 200 µm, bevorzugt von 15 bis 50 µm, aufweisen.

Bei Ausführungsbeispielen kann das Foliensubstrat eines der folgenden Substrate sein: Polyimid, PET (Polyethylenterephthalat), PEN (Polyethylennaphthalat), FR4 (eine Klasse von schwer entflammbaren und flammenhemmenden Verbundwerkstoffen aus Epoxidharz und Glasfasergewebe), PEI (Polyetherimide), LCP (liquid crystal polymer, dt. Flüssigkristallpolymer), PC (Polycarbonate).

Bei Ausführungsbeispielen können Kontaktierung des Halbleiterchips (oder z.B. integrierten Schaltkreises, IC) auf einer Folien-Lage mittels ACA oder ACF Flip-Chip Bond oder auch Löt-Montage und Underfiller erfolgen.

Bei Ausführungsbeispielen kann bei einer sog. "face-up" Montage des Halbleiterchips (oder z.B. integrierten Schaltkreises, IC) direkt kontaktiert werden, z.B. durch Sputtern (z.B. physikalische Gasphasenabscheidung, engl. physical vapour deposition, PVD).

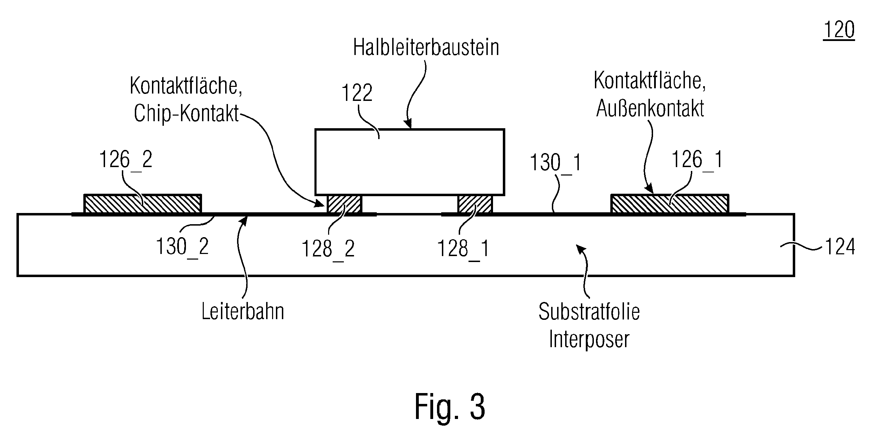

Im Folgenden werden detaillierte Ausführungsbeispiele des Chip-Folien-Moduls 120 anhand der Fig. 3 bis 9 näher beschrieben, die schematische Querschnittansichten unterschiedlicher Ausführungsbeispiele des Chip-Folien-Moduls 120 zeigen. Das Chip-Folien-Modul 120 weist hierbei jeweils einen Halbleiterchip 122, ein Foliensubstrat 124, auf dem der Halbleiterchip 122 angeordnet ist, und zumindest ein von dem Halbleiterchip 122 beabstandetes Kopplungselement 126 auf, das mit zumindest einem Anschluss 128 des Halbleiterchips elektrisch gekoppelt ist.

Fig. 3 zeigt eine schematische Querschnittansicht eines Chip-Folien-Moduls 120, gemäß einem ersten Ausführungsbeispiel. Wie in Fig. 3 zu erkennen ist, weist das Foliensubstrat 124 zumindest zwei von dem Halbleiterchip 122 beabstandetes Kopplungselemente 126_1 und 126_2 auf, die über zwei in oder auf dem Foliensubstrat 124 gebildete Leiterbahnen 130_1 und 130_2 mit zumindest zwei Anschlüssen 128_1 und 128_2 des Halbleiterchips 122 verbunden sind, wobei die zumindest zwei Kopplungselemente 126_1 und 126_2 elektrische Anschlüsse sind.

Mit anderen Worten, Fig. 3 zeigt eine Ausführung des Chip-Folien-Moduls (z.B. Chip-Folien-Interposer), bei dem der Halbleiterchip 122 mittels einer sog. Flip-Chip Montage auf der Substratfolie 124 montiert ist. Die Chip-Kontakte 128_1 und 128_2 sind mit den Leiterbahnen 130_1 und 130_2 auf dem Foliensubstrat 124 (z.B. Interposer-Folie) verbunden und das Chip-Folien-Modul 120 weist weitere Kontaktflächen 126_1 und 126_2 auf. Die Kontaktflächen 126_1 und 126_2 (sog. fan-out Außenkontakte) auf dem Chip-Folien-Modul 120 sind bevorzugt deutlich größer als die Kontaktflächen auf dem Halbleiterchip 122 (z.B. Halbleiterbaustein).

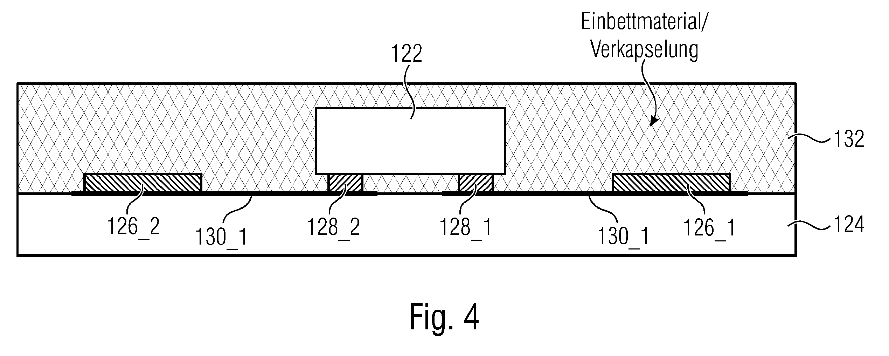

Fig. 4 zeigt eine schematische Querschnittansicht eines Chip-Folien-Moduls 120, gemäß einem zweiten Ausführungsbeispiel. Verglichen mit dem in Fig. 3 gezeigten Ausführungsbeispiel, ist der Halbleiterchip 122 in dem Chip-Folien-Modul 120 in einer Einbettungsschicht 132, die auf dem Foliensubstrat 124 angeordnet ist, (z.B. vollständig) eingebettet.

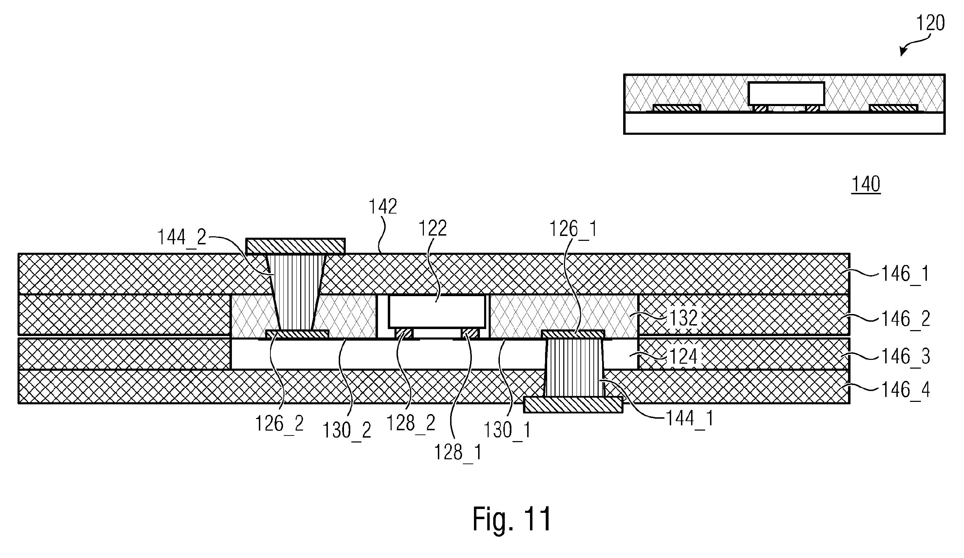

Mit anderen Worten, Fig. 4 zeigt ein Chip-Folien-Modul 120 (z.B. Interposer), bei dem der Halbleiterchip 122 in einem elektrisch isolierenden Material 132, z.B. Polymer, eingebettet ist, somit entsteht ein weitgehend planparalleles Package (dt. Gehäuse). Der Halbleiterchip 122 im Inneren ist gut geschützt. Das in Fig. 4 gezeigte Chip-Folien-Modul 120 weist keine elektrischen Außenkontakte auf. Die Außenkontakte sind erst nach einer späteren Integration in eine Leiterplatte (engl. printed circuit board, PCB) nutzbar (vgl. Fig. 11).

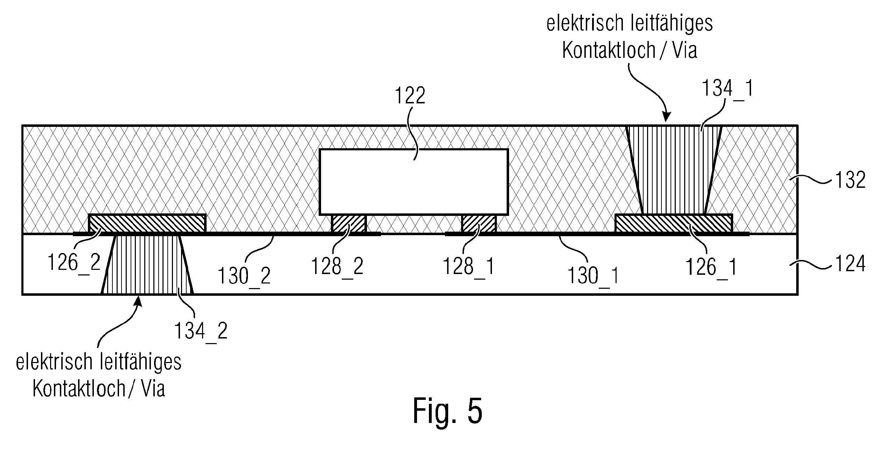

Fig. 5 zeigt eine schematische Querschnittansicht eines Chip-Folien-Moduls 120, gemäß einem dritten Ausführungsbeispiel. Verglichen mit dem in Fig. 4 gezeigten Ausführungsbeispiel, weist das Chip-Folien-Modul 120 ferner zumindest zwei Durchkontaktierungen 134_1 und 134_2 auf, wobei sich die zumindest zwei Durchkontaktierungen 134_1 und 134_2 vertikal durch das Foliensubstrat 124 oder durch die Einbettungsschicht 132 hindurch bis zu den zumindest zwei Anschlüssen 126_1 und 126_2 des Foliensubstrats 124 erstrecken.

Mit anderen Worten, Fig. 5 zeigt ein Chip-Folien-Modul 120 (z.B. Interposer), das auch außenliegende Kontakte an dem Folien-Gehäuse (z.B. Folien-Package) aufweist. Dies kann beispielsweise über eine elektrisch leitfähige Durchkontaktierung 134_1 und 124_2 (engl. Via) durch die Substratfolie 124 oder durch das Verkapselungsmaterial 132 realisiert werden.

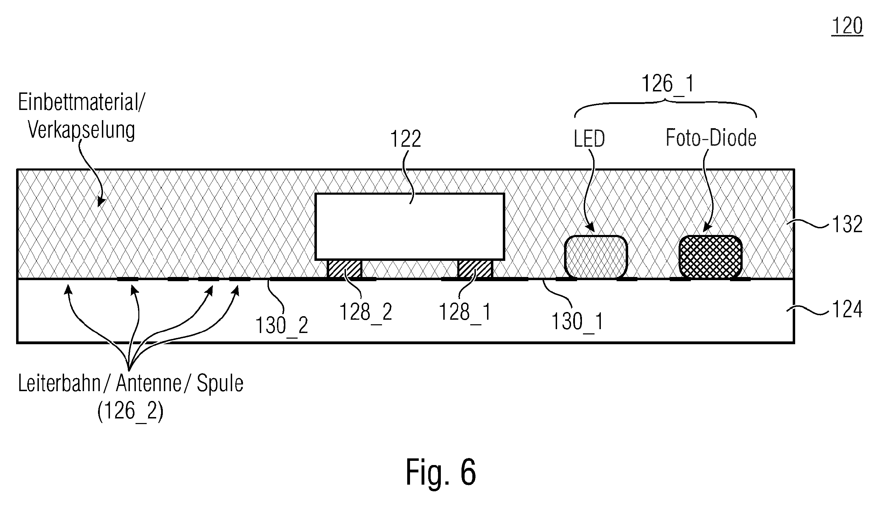

Fig. 6 zeigt eine schematische Querschnittansicht eines Chip-Folien-Moduls 120, gemäß einem vierten Ausführungsbeispiel. Wie in Fig. 6 zu erkennen ist, kann das Foliensubstrat 124 zumindest zwei von dem Halbleiterchip 122 beabstandete Kopplungselemente 126_1 und 126_2 aufweisen, die über zumindest zwei in oder auf dem Foliensubstrat 124 gebildete Leiterbahnen 130_1 und 130_2 mit zumindest zwei Anschlüssen 128_1 und 128_2 des Halbleiterchips 122 verbunden sind. Bei den Kopplungselementen kann es sich um optische Kopplungselemente, wie z.B. eine LED und/oder eine Fotodiode, handeln. Ferner oder alternativ kann es sich bei den Kopplungselementen um induktive, kapazitative oder elektromagnetische Kopplungselemente handeln, wie z.B. eine Leiterschleife, eine Spule, eine Kondensatorplatte und/oder eine Antenne.

Mit anderen Worten, Fig. 6 zeigt ein Chip-Folien-Modul 120 (z.B. Interposer), das keine galvanisch kontaktierbaren Außenkontakte aufweist. Um eine Signalverbindung zu dem Halbleiterchip 122 herzustellen, werden kontaktlose Verbindungen über elektromagnetische oder optische Verbindungswege genutzt. Im ersten Falls kann dies über Antennen erfolgen, bspw. eine Spule oder Dipol-Antenne, im zweiten Fall über eine Fotozelle, die externe Signale von außen aufnimmt, ebenso kann eine LED, die auf dem Chip-Folien-Modul 120 platziert ist, Signale nach außen übertragen. Energieversorgung kann auch über das Einkoppeln von elektromagnetischen Wellen in einer Spule erfolgen.

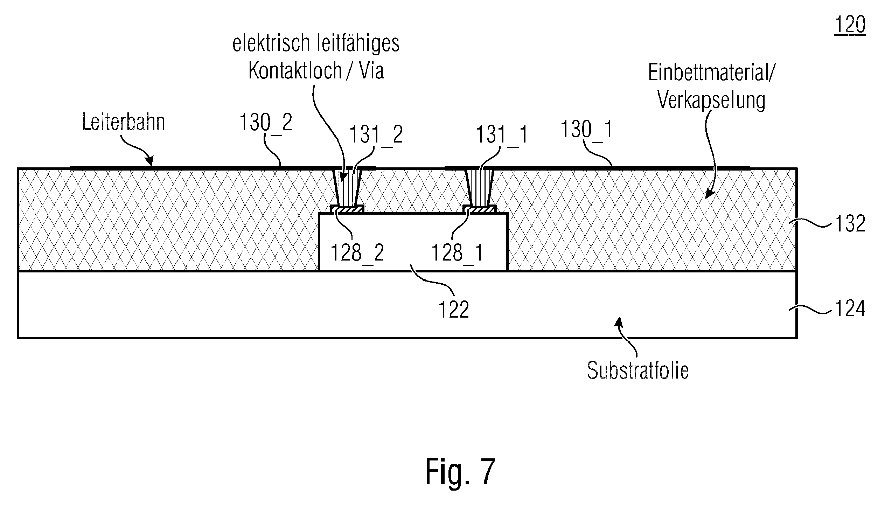

Fig. 7 zeigt eine schematische Querschnittansicht eines Chip-Folien-Moduls 120, gemäß einem fünften Ausführungsbeispiel. Wie in Fig. 7 zu erkennen ist, kann der Halbleiterchip 122 derart auf dem Foliensubstrat 124 angeordnet sein, dass die zumindest zwei Anschlüsse 128_1 und 128_2 des Halbleiterchips 122 dem Foliensubstrat 124 abgewandt sind, wobei die zumindest zwei Anschlüsse 128_1 und 128_2 über zumindest zwei vertikale elektrische Verbindungen 131_1 und 131_2 (z.B. elektrisch leitfähige Kontaktlöcher oder Durchkontaktierungen) mit zumindest zwei Leiterbahnen 130_1 und 132_2 verbunden sind, die in oder auf der Einbettungsschicht 132 des Chip-Folien-Moduls 120 angeordnet sind. Die zumindest zwei Leiterbahnen können hierbei zumindest zwei elektrische Kopplungselemente (elektrische Anschlüsse) bilden.

Mit anderen Worten, Fig. 7 zeigt ein Chip-Folien-Modul 120 (z.B. Interposer), bei dem der Halbleiterchip in sog. "face-up" Orientierung auf der Substratfolie 124 platziert ist. Vorteil hier ist, dass keine Bump-Metallisierungen auf dem Chip-Folien-Modul 120 erforderlich sind. Die Kontakt-Pads 128_1 und 128_2 auf dem Halbleiterchip 122 (z.B. Halbleiterbaustein) werden direkt über aufgedampfte oder gesputterte (z.B. physikalische Gasphasenabscheidung, engl. physical vapor deposition, PVD) Metallschichten kontaktiert.

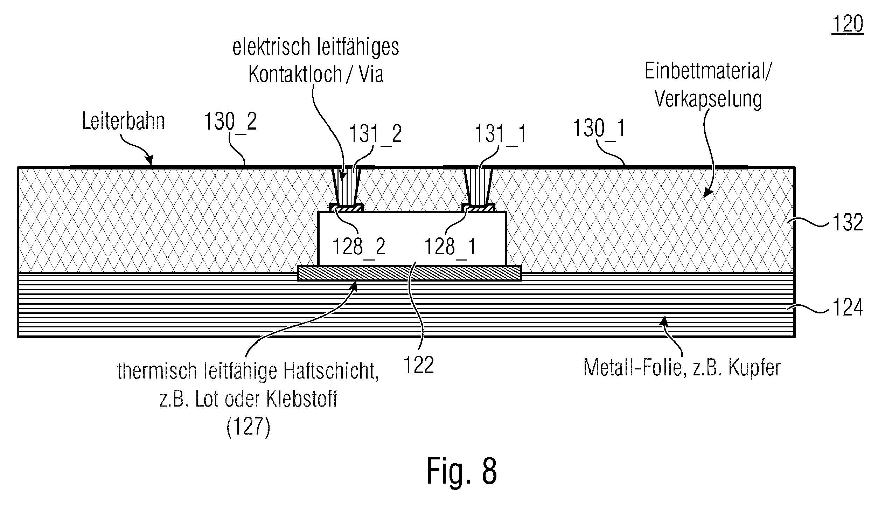

Fig. 8 zeigt eine schematische Querschnittansicht eines Chip-Folien-Moduls 120, gemäß einem sechsten Ausführungsbeispiel. Verglichen mit dem in Fig. 7 gezeigten Ausführungsbeispiel, ist das Foliensubstrat 124 ein thermisch leitfähiges Foliensubstrat. Der Halbleiterchip 122 kann hierbei über eine thermisch leitfähige Haftschicht 127, z.B. Lot oder Klebstoff, mit dem thermisch leitfähigen Foliensubstrat 124 verbunden sein.

Mit anderen Worten, Fig. 8 zeigt ein Chip-Folien-Modul (z.B. Interposer), dessen Substrafolie 124 eine Metallfolie, wie z.B. Kupferfolie, ist. Wenn der Halbleiterchip 122 (z.B. Halbleiterbaustein) mit seiner Rückseite mittels eine Lotverbindung oder thermisch leitfähigen Haftschicht auf der Kupferfolie montiert ist, dann kann eine mögliche Wärmeentwicklung im Halbleiterchip 122 sehr effizient über die Rückseite abgeleitet werden.

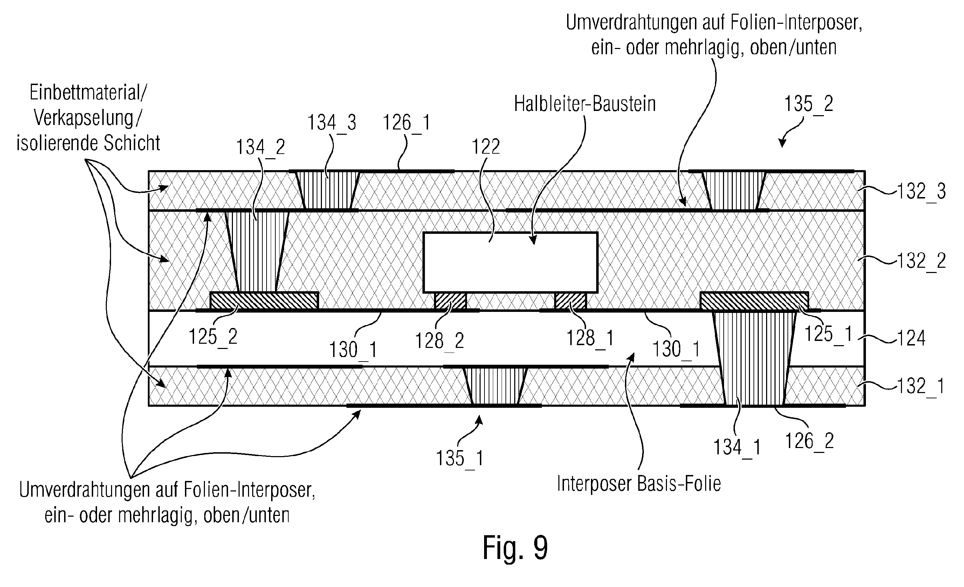

Fig. 9 zeigt eine schematische Querschnittansicht eines Chip-Folien-Moduls 120, gemäß einem siebten Ausführungsbeispiel. Wie in Fig. 9 zu erkennen ist, kann das Foliensubstrat 124 zumindest zwei Anschlusselemente 125_1 und 125_2 aufweisen, die über zumindest zwei in auf der dem Foliensubstrat gebildeten Leiterbahnen 130_1 und 130_2 mit zumindest zwei Anschlüssen 128_1 und 128_2 des Halbleiterchips 122 verbunden sind, wobei das Chip-Folien-Modul 120 zumindest zwei übereinander liegende oder gestapelte Einbettungsschichten 132_1-132_3 aufweist, die den Halbleiterchip 122 und/oder das Foliensubstrat 124 einbetten, wobei das Chip-Folien-Modul 120 zumindest zwei Kopplungselemente 126_1 und 126_2 aufweist, die in oder auf unterschiedlichen Einbettungsschichten 132_1 und 132_2 der zumindest zwei Einbettungsschichten 132_1-132_3 angeordnet sind, wobei die zumindest zwei Kopplungselemente über vertikale elektrische Verbindungen 134_1-134_3 mit den zumindest zwei Kopplungselementen 126_1 und 126_2, z.B. elektrische Anschlüsse, verbunden sind. Natürlich kann das Chip-Folien-Modul auch noch weitere Umverdrahtungen 135_1 und 135_2 aufweisen.

Mit anderen Worten, Fig. 9 zeigt ein Chip-Folien-Modul (z.B. Interposer), der eine mehrlagige Umverdrahtung aufweist; diese kann einseitig oder beidseitig sein. Mit anderen Worten, Fig. 9 zeigt ein Folien-Package mit Mehrlagen-Umverdrahtung.

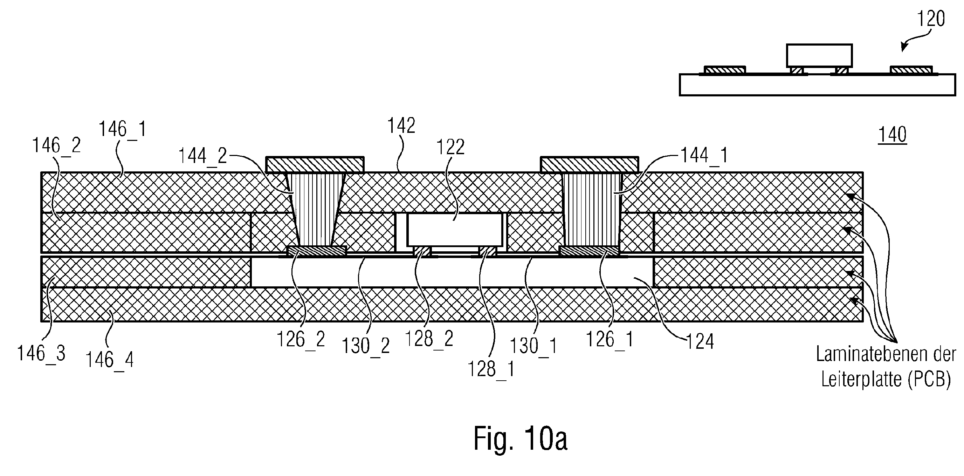

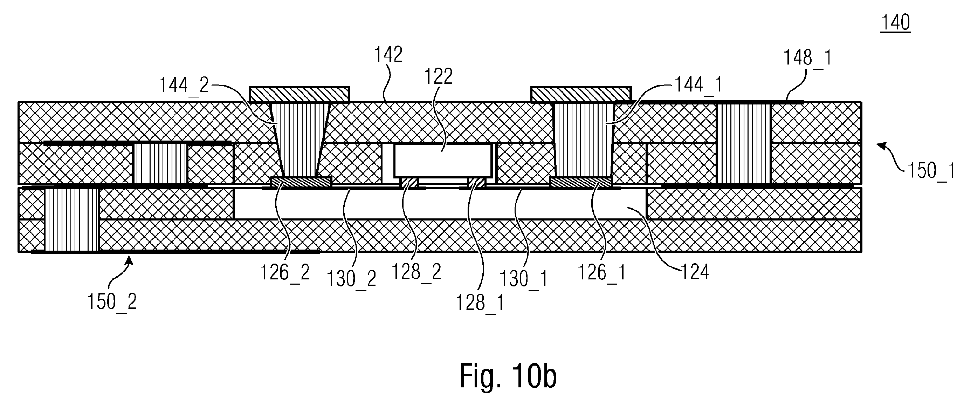

Im Folgenden werden detaillierte Ausführungsbeispiele einer mikroelektronischen Anordnung anhand der Fig. 10 bis 18 näher beschrieben, die durch Integration (z.B. Einbettung) der in den Fig. 3 bis 9 gezeigten Chip-Folien-Module 120 in eine Leiterplatte (engl. printed circuit board, PCB) resultieren. Bei der Integration des jeweiligen Chip-Folien-Moduls 120 in die Leiterplatte wird das zumindest eine Kopplungselement 126 des Chip-Folien-Moduls 120 vertikal mit zumindest einem Kopplungsgegenelement 144 der Leiterplatte 142 gekoppelt.

Es sei hierbei darauf hingewiesen, dass, obwohl Leiterbahnebenen exemplarisch in nur einigen der Fig. 10 bis 16 eingezeichnet sind, diese grundsätzlich vorhanden sein können und Umverdrahtungen auf den Lagen der Leiterplatte auch mehrlagig sein können.

Fig. 10a zeigt eine schematische Querschnittsansicht einer mikroelektronischen Anordnung 140 mit einer Leiterplatte 142 und dem in die Leiterplatte 142 eingebetteten Chip-Folien-Modul aus Fig. 3 (Chip-Folien-Interposer aus Fig. 3 integriert in PCB), gemäß einem ersten Ausführungsbeispiel. Wie in Fig. 10a zu erkennen ist, kann die Leiterplatte 142 mehrere Laminatebenen 146_1-146_4 aufweisen, in die das Chip-Folien-Modul 120 (z.B. vollständig) eingebettet ist. Wie in Fig. 10a ferner zu erkennen ist, können die zumindest zwei Anschlüsse 126_1 und 126_2 (Kopplungselemente) des Chip-Folien-Moduls 120 mit zumindest zwei Durchkontaktierungen 144_1 und 144_2 (Gegenkopplungselemente) der Leiterplatte 142 verbunden sein. Die Durchkontaktierungen 144_1 und 144_2 können hierbei mit Leiterbahnen 148_1 der Leiterplatte 142 verbunden sein, wie dies in Fig. 10b gezeigt ist. Ferner kann die Leiterplatte 142 mehrlagige Umverdrahtungen 150_1 und 150_2 aufweisen.

Mit anderen Worten, Fig. 10a und 10b zeigen eine Integration des Chip-Folien-Moduls 120 aus Fig. 3 in die Leiterplatte 142. Fig. 10a zeigt hierbei das in der Leitplatte 142 eingebettete Chip-Folien-Modul (z.B. Interposer). Exemplarisch ist Fig. 10b auch gezeigt, wie Leiterbahnen in der Leiterplatte 142 auf verschiedenen Ebenen geführt sind und wie elektrische Kontaktierungen (Via) zwischen den einzelnen Leiterbahnebenen ausgeführt werden können.

Bei dem in den Fig. 10a und 10b gezeigten Ausführungsbeispiel, enden die Via-Kontakte 144_1 und 144_2 der Leiterplatten-Technologie auf Kontakt-Pads 126_1 und 126_2 des Chip-Folien-Moduls 120 (z.B. Folien-Interposers). Diese Vias 144_1 und 144_2 können beispielsweise durch mechanisches Bohren oder Laser-Bohren erzeugt werden. Die offenen Vias werden dann mit einer Metallisierungsschicht versehen und üblicherweise mittels eines Galvanik-Prozesses mit Kupfer gefüllt.

Fig. 11 zeigt eine schematische Querschnittsansicht einer mikroelektronischen Anordnung 140 mit einer Leiterplatte 142 und dem in die Leiterplatte 142 eingebetteten Chip-Folien-Modul aus Fig. 4 (Chip-Folien-Interposer aus Fig. 4 integriert in PCB), gemäß einem zweiten Ausführungsbeispiel. Wie in Fig. 11 zu erkennen ist, kann die Leiterplatte 142 mehrere Laminatebenen 146_1-146_4 aufweisen, in die das Chip-Folien-Modul 120 (z.B. vollständig) eingebettet ist. Wie in Fig. 11 ferner zu erkennen ist, können die zumindest zwei Anschlüsse 126_1 und 126_2 (Kopplungselemente) des Chip-Folien-Moduls 120 mit zumindest zwei Durchkontaktierungen 144_1 und 144_2 (Gegenkopplungselemente) der Leiterplatte 142 verbunden sein. Hierbei können sich die zumindest zwei Durchkontaktierungen 144_1 und 144_2 vertikal durch das Foliensubstrat 124 oder durch die Einbettungsschicht 132 hindurch bis zu den zumindest zwei Anschlüssen 126_1 und 126_2 des Foliensubstrats 124 erstrecken.

Mit anderen Worten, Fig. 11 zeigt eine Integration des in Fig. 4 gezeigten Chip-Folien-Moduls 120 in eine Leiterplatte. In diesem Fall können die Durchkontaktierungen 144_1 und 144_2 (Vias) der Leiterplatten-Technologie sowohl die Laminatebenen der Leiterplatte als auch entweder das Chip-Einbettmaterial 132 des Chip-Folien-Moduls 120 (Folien-Interposer) oder, bei Kontaktierung von der Unterseite, die Substratfolie 124 des Chip-Folien-Moduls 120 (z.B. Interposers) durchdringen.

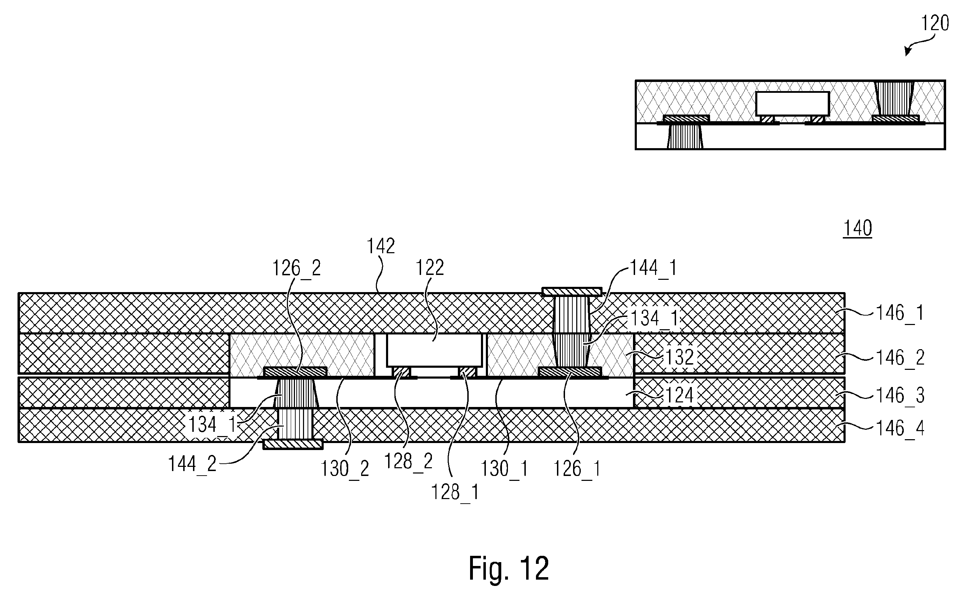

Fig. 12 zeigt eine schematische Querschnittsansicht einer mikroelektronischen Anordnung 140 mit einer Leiterplatte 142 und dem in die Leiterplatte 142 eingebetteten Chip-Folien-Modul aus Fig. 5 (Chip-Folien-Interposer aus Fig. 5 integriert in PCB), gemäß einem dritten Ausführungsbeispiel. Wie in Fig. 12 zu erkennen ist, kann die Leiterplatte 142 mehrere Laminatebenen 146_1-146_4 aufweisen, in die das Chip-Folien-Modul 120 (z.B. vollständig) eingebettet ist. Wie in Fig. 12 ferner zu erkennen ist, können die zumindest zwei Anschlüsse 126_1 und 126_2 (Kopplungselemente) des Chip-Folien-Moduls 120, welche über zumindest zwei Durchkontaktierungen 134_1 und 134_2 nach außen geführt sind, mit zumindest zwei Durchkontaktierungen 144_1 und 144_2 (Gegenkopplungselemente) der Leiterplatte 142 verbunden sein.

Mit anderen Worten, Fig. 12 zeigt eine Integration des in Fig. 5 gezeigten Chip-Folien-Moduls 120 (z.B. Interposers). In diesem Fall enden die Durchkontaktierungen 144_1 und 144_2 (Vias) der Leiterplatten-Technologie auf den außenliegenden Kontaktflächen 134_1 und 134_2 des Chip-Folien-Moduls 120.

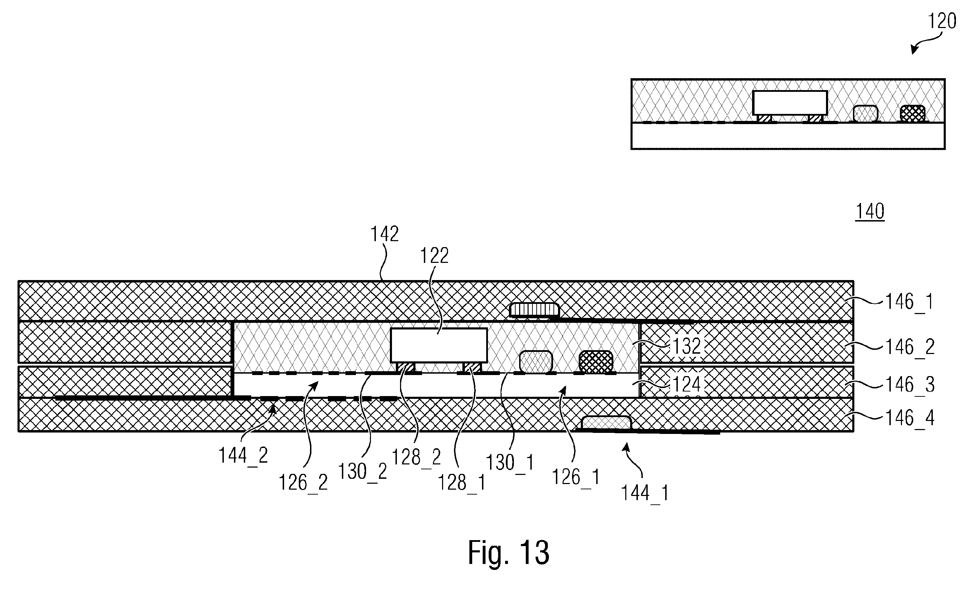

Fig. 13 zeigt eine schematische Querschnittsansicht einer mikroelektronischen Anordnung 140 mit einer Leiterplatte 142 und dem in die Leiterplatte 142 eingebetteten Chip-Folien-Modul aus Fig. 6 (Chip-Folien-Interposer aus Fig. 6 integriert in PCB), gemäß einem vierten Ausführungsbeispiel. Wie in Fig. 13 zu erkennen ist, kann die Leiterplatte 142 mehrere Laminatebenen 146_1-146_4 aufweisen, in die das Chip-Folien-Modul 120 (z.B. vollständig) eingebettet ist. Wie in Fig. 13 ferner zu erkennen ist, kann die Leiterplatte zumindest zwei Kopplungsgegenelemente 144_1 und 144_2 aufweisen, die mit den zumindest zwei Kopplungselementen 126_1 und 126_2 des Chip-Folien-Moduls 120 vertikal gekoppelt sind. Bei den Kopplungsgegenelementen kann es sich um optische Kopplungselemente, wie z.B. eine LED und/oder eine Fotodiode, handeln. Ferner oder alternativ kann es sich bei den Kopplungsgegenelementen um induktive, kapazitative oder elektromagnetische Kopplungselemente handeln, wie z.B. eine Leiterschleife, eine Spule, eine Kondensatorplatte und/oder eine Antenne.

Mit anderen Worten, Fig. 13 zeigt eine Integration des in Fig. 6 gezeigten Chip-Folien-Moduls 120 (z.B. Interposers). In diesem Fall gibt es keine galvanische Kopplung zwischen Leiterbahnen der Leiterplatte 142 und dem Halbleiterchip 122 (z.B. Chip-Baustein). Stattdessen sind entweder Antennen oder optoelektronische Signalkopplungen zwischen den Leiterbahnen der Leiterplatte 142 und den Leiterbahnen des Chip-Folien-Moduls 120 vorgesehen. Die Kopplungseinrichtungen (Kopplungselemente 126_1 und 126_2 und Kopplungsgegenelemente 144_1 und 144_2) sind komplementär auszuführen, also Antenne über Antenne oder LED gegenüber Fotozelle.

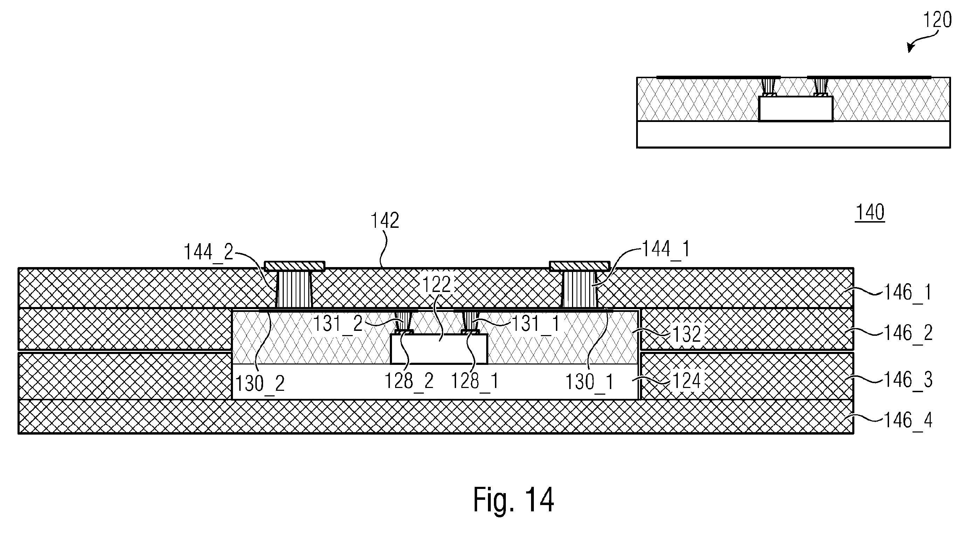

Fig. 14 zeigt eine schematische Querschnittsansicht einer mikroelektronischen Anordnung 140 mit einer Leiterplatte 142 und dem in die Leiterplatte 142 eingebetteten Chip-Folien-Modul aus Fig. 7 (Chip-Folien-Interposer aus Fig. 7 integriert in PCB), gemäß einem fünften Ausführungsbeispiel. Wie in Fig. 14 zu erkennen ist, kann die Leiterplatte 142 mehrere Laminatebenen 146_1-146_4 aufweisen, in die das Chip-Folien-Modul 120 (z.B. vollständig) eingebettet ist. Wie in Fig. 14 ferner zu erkennen ist, können die zumindest zwei Leiterbahnen 130_1 und 130_2 des Chip-Folien-Moduls 120, welche zumindest zwei elektrische Anschlüsse bilden, mittels zumindest zwei Durchkontaktierungen 144_1 und 144_2 der Leiterplatte 142 angekoppelt sein.

Mit anderen Worten, Fig. 14 zeigt eine Integration des in Fig. 7 gezeigten Chip-Folien-Moduls 120 (z.B. Interposers).

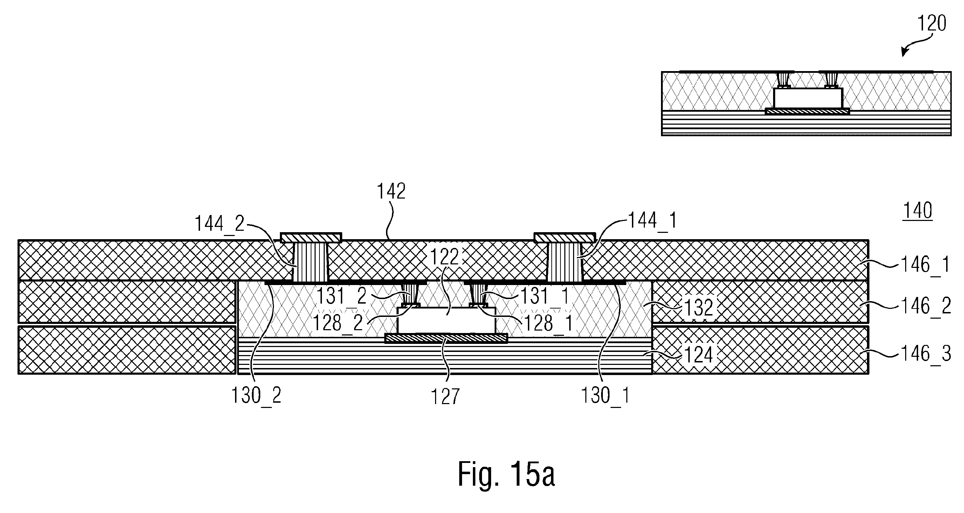

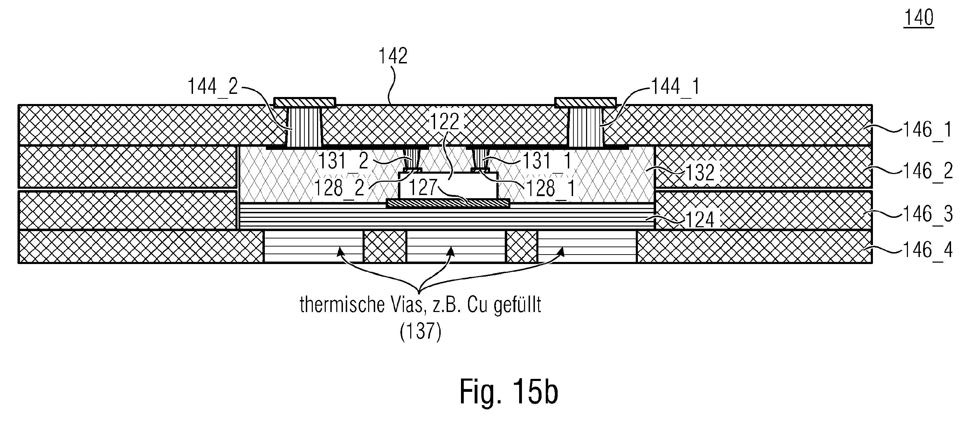

Fig. 15a zeigt eine schematische Querschnittsansicht einer mikroelektronischen Anordnung 140 mit einer Leiterplatte 142 und dem in die Leiterplatte 142 eingebetteten Chip-Folien-Modul aus Fig. 8 (Chip-Folien-Interposer aus Fig. 8 integriert in PCB), gemäß einem sechsten Ausführungsbeispiel. Wie in Fig. 15a zu erkennen ist, können die zumindest zwei Leiterbahnen 130_1 und 130_2 des Chip-Folien-Moduls 120, welche zumindest zwei elektrische Anschlüsse bilden, mittels zumindest zwei Durchkontaktierungen 144_1 und 144_2 der Leiterplatte 142 angekoppelt sein. Wie in Fig. 15a ferner zu erkennen ist, kann die Leiterplatte 142 mehrere Laminatebenen 146_1-146_3 aufweisen, in die das Chip-Folien-Modul 120 derart eingebettet sein, dass die thermisch leitfähige Foliensubstrat 124 des Chip-Folien-Moduls 120 freiliegt, d.h. nicht eingebettet ist (z.B. mit einer Oberfläche (z.B. Unterseite) der Leiterplatte 142 im Wesentlichen bündig abschließt). Alternativ kann das Chip-Folien-Modul 120 auch vollständig in die Leiterplatte 142 eingebettet sein z.B. mittels einer weiteren Laminatebene 146_4, wie dies in Fig. 15b gezeigt ist, wobei in diesen Fall die Leiterplatte 142 benachbart zu dem thermisch leitfähigen Foliensubstrat 124 (z.B. innerhalb der vierten Laminatebene 146_4) thermische Durchkontaktierung 137 aufweist, die ausgebildet sind, um thermische Energie von dem thermisch leitfähigen Foliensubstrat 124 an eine Umgebung der Leiterplatte 142 zu leiten.

Mit anderen Worten, Fig. 15a und 15b zeigen Integrationen des in Fig. 8 gezeigten Chip-Folien-Moduls 120 (z.B. Interposers), bei dem die Basis-Folie 124 eine thermisch leitfähige Folie, wie z.B. eine Kupferfolie, ist. Hierzu sind zwei mögliche Varianten gezeigt: Die thermisch leitfähige Folie (z.B. Cu-Folie) des Chip-Folien-Moduls 120 (z.B. Interposers) bleibt nach der Integration in die Leiterplatte 142 (PCB) an der Rückseite offen; kann also auf einem weiteren Substrat (hier nicht gezeichnet) aufgelötet werden oder mit einer Luft- oder Flüssigkeitskühlung in Kontakt gebracht werden. Zweite Ausführung: Das Chip-Folien-Modul 120 ist vollständig in der Leiterplatte 142 (PCB) eingebettet. Um die Wärmeableitung dennoch hoch zu halten, werden sogenannte thermische Durchkontaktierungen 137 (z.B. Vias) unter dem Chip-Folien-Moduls 120 (z.B. Interposer) angefertigt; bevorzugt mit metallischen Verbindungstechnologien (Löten, Sintern) oder hoch-wärmeleitfähigen Materialein wie Graphit, Aluminiumnitrid u. a..

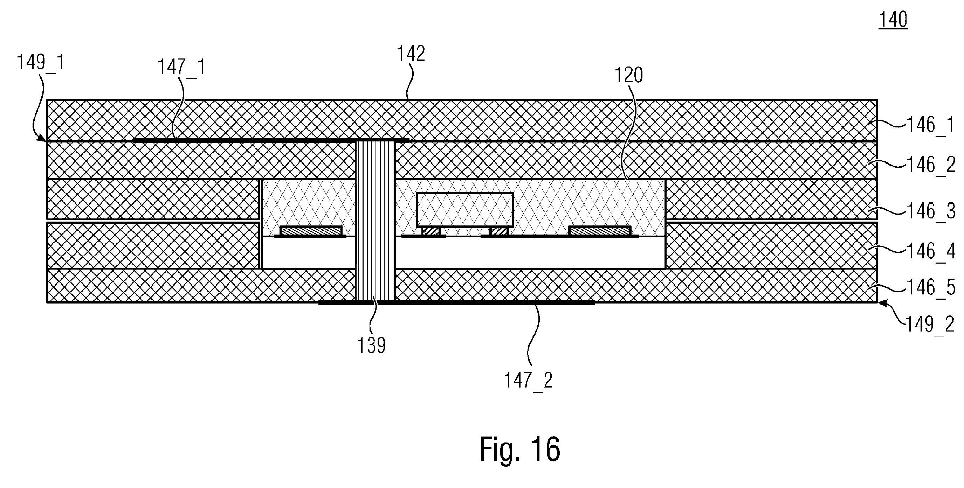

Fig. 16 zeigt eine schematische Querschnittsansicht einer mikroelektronischen Anordnung 140 mit einer Leiterplatte 142 und einem beliebigen in die Leiterplatte 142 eingebetteten Chip-Folien-Modul 120, gemäß einem siebten Ausführungsbeispiel. Wie in Fig. 16 zu erkennen ist, kann die Leiterplatte 142 mehrere Laminatebenen 146_1-146_5 aufweisen, in die das Chip-Folien-Modul 120 (z.B. vollständig) eingebettet ist. Wie in Fig. 16 ferner zu erkennen ist, kann die Leiterplatte 142 zumindest zwei Leiterbahnebenen 149_1 und 149_2 aufweisen, wobei das Chip-Folien-Modul 120 zwischen den zumindest zwei Leiterbahnebenen 149_1 und 149_2 angeordnet ist, wobei bei dem Einbetten des Chip-Folien-Moduls 120 in die Leiterplatte 142 eine vertikale Durchkontaktierung 139 durch das Chip-Folien-Modul 120 hindurch zum Verbinden von Leiterbahnen 147_1 und 147_2 der zumindest zwei Leiterbahnebenen 149_1 und 149_2 gebildet wird.

Mit anderen Worten, Fig. 16 zeigt eine Integration eines beliebigen Chip-Folien-Moduls 120 (z.B. eines der in den Fig. 3 bis 9 gezeigten Chip-Folien-Module) in eine Leiterplatte 142. Bei dem in Fig. 16 gezeigten Ausführungsbeispiel wird eine Durchkontaktierung 139 (z.B. Via) der Leiterplatten (PCB) Technologie durch das Chip-Folien-Modul 120 (z.B. Folien-Interposer) hindurchführt ohne dabei einen elektrischen Kontakt mit den Leiterbahnen des Chip-Folien-Moduls 120 einzugehen. Es können auch Verdrahtungswege auf dem Chip-Folien-Modul 120, die keinen Kontakt mit dem Halbleiterchip 122 (z.B. Halbleiterbaustein) haben, mit Verdrahtungswegen der Leiterplatte 142 kombiniert werden. Dies hat Vorteile: bspw. geht die Fläche des Chip-Folien-Modul 120 für die Ausführung der Verdrahtung (auch als "routing" bezeichnet) nicht verloren. Trotz des Chip-Folien-Moduls 120 kann also eine hochdichte Verdrahtung auf der Leiterplatte 142 (PCB) erzielt werden. Außerdem können sichere Verdrahtungskonzepte in der Schaltungs-Architektur geplant und ausgeführt werden, bspw. in dem ein Teil der Verdrahtung des Gesamtsystems auf dem Chip-Folien-Modul 120 abgebildet wird und ein anderer Teil im Leiterplatten (PCB) Layout. Dies bringt neue Möglichkeiten in der Fälschungssicherheit des Systems. Beispiel: IC Design, Interposer Design und PCB Design werden von verschiedenen Dienstleistern ausgeführt; dann hat nur der Auftraggeber das vollständige Wissen über die erforderlichen Kontaktierungswege und Funktionalitäten des Gesamtsystems. Ein Nachbau oder Kopie des elektrischen Gesamtsystems sind somit erheblich erschwert.

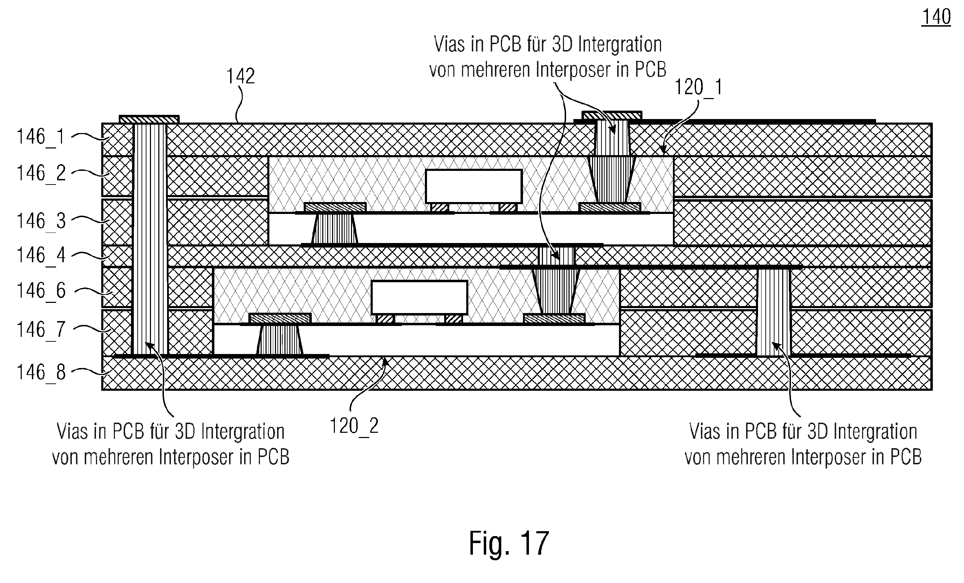

Fig. 17 zeigt eine schematische Querschnittsansicht einer mikroelektronischen Anordnung 140 mit einer Leiterplatte 142 und zwei beliebigen in die Leiterplatte 142 eingebetteten Chip-Folien-Modulen 120, gemäß einem achten Ausführungsbeispiel. Wie in Fig. 17 zu erkennen ist, können die beiden Chip-Folien-Module 120 in vertikaler Richtung der Leiterplatte 142 gestapelt sein und durch mehrere Laminatebenen 146_1-146_8 vollständig in die Leiterplatte 142 eingebettet sein.

Mit anderen Worten, Fig. 17 zeigt eine Möglichkeit zur mehrfachen dreidimensionalen Integration von Chip-Folien-Modulen 120 (z.B. Folien-Interposern) in einer Leiterplatte 142. Dies ist nur möglich, da die dünnen folienbasierten Chip-Folien-Modulen 120 gut integrierbar und stapelbar sind.

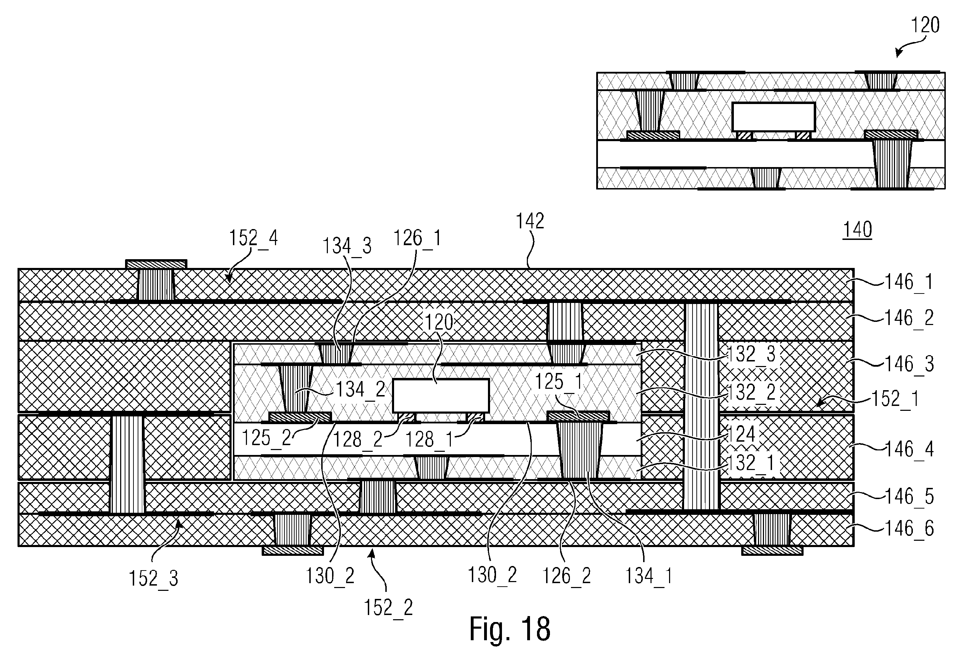

Fig. 18 zeigt eine schematische Querschnittsansicht einer mikroelektronischen Anordnung 140 mit einer Leiterplatte 142 und dem in die Leiterplatte 142 eingebetteten Chip-Folien-Modul 120 aus Fig. 9 (Chip-Folien-Interposer aus Fig. 9 integriert in PCB), gemäß einem neunten Ausführungsbeispiel. Wie in Fig. 18 zu erkennen ist, kann das Chip-Folien-Modul 120 vollständig in die Leiterplatte 120 eingebettet sein, z.B. durch mehrere Laminatebenen 146_1-146_6. Wie in Fig. 18 ferner zu erkennen ist, kann auch die Leiterplatte 142 mehrere mehrlagige Umverdrahtungen 152_1-152_4 aufweisen.

Mit anderen Worten, Fig. 18 zeigt die Integration des in Fig. 9 gezeigten Chip-Folien-Moduls 120 (z.B. Interposer) in eine Leiterplatte 142, der selbst schon eine Mehrlagenumverdrahtung auf oder in dem Folien-Interposer aufweist.

Das Chip-Folien-Modul 120 aus den Fig. 9 bzw. 18 ist besonders vorteilhaft, weil dadurch auch Halbleiterbausteine mit vielen Kontakt-Pads auf dem Chip, z. B. Prozessoren, in einen Chip-Folien-Modul 120 integriert werden können. Dies ist wiederum ein besonderes Merkmal eines Chip-Folien-Modul 120, weil die Mehrlagigkeit auf polymeren Schichten technologisch gut machbar ist.

Im Folgenden werden Vorteile von Ausführungsbeispielen der vorliegenden Erfindung beschrieben.

Bei Ausführungsbeispielen wird die erforderliche Aufweitung der sehr kleinen Kontakt-Pads auf einem Halbleiterchip (z.B. Halbleiter-Baustein) auf einem Chip-Folien-Modul (z.B. Folien-Interposer) realisiert, ebenso die Ausführung von Kontakt-Pads mit ausreichend stabiler (= dicker) Metallisierung (z.B. 2 - 5 µm dicke Kupfer-Pads, ggf. auch mit Vergoldung als Oxidationsschutz). Es entfällt somit die technologische Realisierung einer UmverdrahtungsEbene am Ausgangs-Wafer des Halbleiterchips in einer Wafer-Fabrik wie es herkömmlicherweise der Fall ist.

Die andererseits notwendigen zusätzlichen Verfahrensschritte zur Herstellung des Chip-Folien-Moduls (z.B. Folien-Interposers) auf kostengünstigen großflächigen Substratfolien können mit vereinfachter Prozesstechnik (nicht sub-µm Prozesstechnik in teuren Reinsträumen der Wafer-Fabs) in sauberen Labors großflächig und damit im kosteneffizienten Mehrfachnutzen und automatisiert ausgeführt werden. Es bieten sich hier insbesondere auch Rolle-zu-Rolle Prozesstechniken für die Herstellung der Leiterbahnen auf dem Foliensubstrat und auch zur Montage der ungehäusten Chips (automatisiertes pick & place aus dem Waferverbund) an. Dieser Zwischenschritt ist gewissermaßen der Kompromiss zwischen hoch aufgelösten lithografischen Prozessen in sauberen Labors (nicht unbedingt Reinraum der Wafer-Fabriken) und den eher einfacheren Prozessumgebungen in einer üblichen Leiterplattenfertigung.

Die Verarbeitung von dünnen Halbleiterchips (z.B. Halbleiterbausteinen) in einer Leiterplattenfabrik stellt eine große Herausforderung dar, weil ungehäuste dünne Chips sehr bruchgefährdet sind. Das Chip-Folien-Modul (z.B. Folien-Interposer) bietet dagegen einen guten Schutz für den Halbleiterchip (z.B. IC Baustein), somit kann mit schnellen und robust ausgelegten Prozessen und Maschinen in der PCB Fabrikation gearbeitet werden.

Die Kombination der Verdrahtungsstrukturen (Layout) auf dem Chip-Folien-Modul (z.B. Interposer) und auf den Leiterplattenebenen ermöglicht neue Sicherheitsmerkmale für schützenswerte Elektroniken (z.B. crypto server, Codierungsverfahren, Kopierschutz, Originalitätsnachweis). Siehe auch Erläuterungen zu Fig. 16.

Das Verfahren ermöglicht höhere Integrationsdichten in der Systemarchitektur, da es kürzere Verbindungswege zwischen mehreren Halbleiterchips (z.B. IC-Bausteinen) ermöglicht, insbesondere bei dreidimensional gestapelten Chip-Folien-Modulen.
Für das Ziel einer dreidimensionalen Integration / hohe Integrationsdichte nutzt das Verfahren einfachere, kostengünstigere und leichter verfügbare Prozesstechniken als eine Waferbasierte Integrationstechnologie auf der Basis von Wafer-Fab-Infrastrukturen und deren teure Prozesstechniken.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren (100) zur Herstellung einer mikroelektronischen Anordnung (140), mit folgenden Schritten:
Bereitstellen (102) eines Chip-Folien-Moduls (120) mit einem Halbleiterchip (122) und einem Foliensubstrat (124), auf dem der Halbleiterchip (122) angeordnet ist, wobei das Chip-Folien-Modul (120) zumindest ein von dem Halbleiterchip (122) beabstandetes Kopplungselement (126; 126_1,126_2) aufweist, das mit zumindest einem Anschluss (128; 128_1-128_2) des Halbleiterchips (122) elektrisch gekoppelt ist, und
Einbetten (104) des Chip-Folien-Moduls (120) in eine Leiterplatte (142), wobei bei dem Einbetten des Chip-Folien-Moduls (120) in die Leiterplatte (142) das zumindest eine Kopplungselement (126; 126_1,126_2) des Chip-Folien-Moduls (120) vertikal mit zumindest einem Kopplungsgegenelement (144; 144_1,144_2) der Leiterplatte (142) gekoppelt wird.

2. Verfahren (100) nach dem vorangehenden Anspruch,
wobei zumindest ein Kopplungselement des zumindest einen Kopplungselements (126; 126_1,126_2) des Chip-Folien-Moduls (120) ein elektrischer Anschluss ist,
wobei zumindest ein Kopplungsgegenelement des zumindest einen Kopplungsgegenelements (144; 144_1,144_2) der Leiterplatte (142) eine Durchkontaktierung ist.

3. Verfahren (100) nach dem vorangehenden Anspruch,
wobei eine Anschlussfläche des Anschlusses des Chip-Folien-Moduls (120) größer ist als eine Anschlussfläche des Anschlusses (128; 128_1-128_2) des Halbleiterchips (122),
und/oder wobei Abstände zwischen Anschlüssen des Chip-Folien-Moduls (120) größer sind als Abstände zwischen Anschlüssen (128; 128_1-128_2) des Hableiterchips (122).

4. Verfahren (100) nach einem der vorangehenden Ansprüche,
wobei zumindest ein Kopplungselement des zumindest einen Kopplungselements (126; 126_1,126_2) des Chip-Folien-Moduls (120) ein optisches Kopplungselement ist,
wobei zumindest ein Kopplungsgegenelement des zumindest einen Kopplungsgegenelements (144; 144_1,144_2) der Leiterplatte (142) ein optisches Kopplungsgegenelement ist.

5. Verfahren (100) nach einem der vorangehenden Ansprüche,
wobei zumindest ein Kopplungselement des zumindest einen Kopplungselements (126; 126_1,126_2) des Chip-Folien-Moduls (120) ein induktives oder kapazitives Kopplungselement ist,
wobei zumindest ein Kopplungsgegenelement des zumindest einen Kopplungsgegenelements (144; 144_1,144_2) der Leiterplatte (142) ein induktives oder kapazitives Kopplungsgegenelement ist.

6. Verfahren (100) nach einem der vorangehenden Ansprüche,
wobei der Halbleiterchip (122) in dem Chip-Folien-Modul (120) eingebettet ist.

7. Verfahren (100) nach einem der Ansprüche 1 bis 6,
wobei das zumindest eine Kopplungselement (126; 126_1,126_2) auf oder in dem Foliensubstrat (124) angeordnet ist und über zumindest eine auf oder in dem Foliensubstrat (124) gebildete Leiterbahn (130; 130_1-130_2) mit dem zumindest einen Anschluss (128; 128_1-128_2) des Halbleiterchips (122) verbunden ist.

8. Verfahren (100) nach einem der Ansprüche 1 bis 6,
wobei der Halbleiterchip (122) derart auf dem Foliensubstrat (124) angeordnet ist, dass der zumindest eine Anschluss (128; 128_1-128_2) des Halbleiterchips (122) dem Foliensubstrat (124) abgewandt ist,
wobei das zumindest eine Kopplungselement (126; 126_1,126_2) in oder auf einer Einbettungsschicht (132) des Chip-Folien-Moduls (120) angeordnet ist, in der der Halbleiterchip (122) eingebettet ist,
wobei das zumindest eine Kopplungselement (126; 126_1,126_2) über eine vertikale elektrische Verbindung (131_1-131_2) mit dem zumindest einen Anschluss (128; 128_1-128_2) des Halbleiterchips (122) verbunden ist.

9. Verfahren (100) nach einem der Ansprüche 1 bis 6,
wobei das Foliensubstrat (124) zumindest zwei Anschlusselemente (125_1-125_2) aufweist, die über zumindest zwei in auf der dem Foliensubstrat (124) gebildeten Leiterbahnen (130_1,130_2) mit zumindest zwei Anschlüssen (128_1-128_2) des Halbleiterchips (122) verbunden sind,
wobei das Chip-Folien-Modul (120) zumindest zwei übereinander liegende oder gestapelte Einbettungsschichten (130_1,130_2,...) aufweist, die den Halbleiterchip (122) und/oder das Foliensubstrat (124) einbetten,
wobei das Chip-Folien-Modul (120) zumindest zwei Kopplungselemente (126_1,126_2) aufweist, die in oder auf unterschiedlichen Einbettungsschichten der zumindest zwei Einbettungsschichten (130_1,130_2,...) angeordnet sind,
wobei die zumindest zwei Kopplungselemente (126_1,126_2) über vertikale elektrische Verbindungen (134_1-124_2) mit den zumindest zwei Anschlusselementen (125_1-125_2) des Foliensubstrats (124) verbunden sind.

10. Verfahren (100) nach einem der vorangehenden Ansprüche,
wobei die Leiterplatte (142) zumindest zwei Laminatebenen (144_1,144_2,...) aufweist, in der das Chip-Folien-Modul (120) eingebettet ist.

11. Verfahren (100) nach einem der vorangehenden Ansprüche,
wobei der Halbleiterchip (122) über das zumindest eine Kopplungselement (126; 126_1,126_2) des Chip-Folien-Moduls (120) und das zumindest eine Kopplungsgegenelement (144; 144_1,144_2) der Leiterplatte (142) mit zumindest einer Schaltungskomponente (150) der Leiterplatte (142) verbunden ist.

12. Verfahren (100) nach einem der vorangehenden Ansprüche,
wobei der Schritt des Bereitstellens (102) des Chip-Folien-Moduls (120) aufweist:
Bereitstellen des Halbleiterchips (122),
Bereitstellen des Foliensubstrats (124),
Verbinden des Halbleiterchips (122) mit dem Foliensubstrat (124),

13. Verfahren (100) nach dem vorangehenden Anspruch,
wobei der Schritt des Bereitstellens (102)des Chip-Folien-Moduls (120) ferner aufweist:
Einbetten des Halbleiterchips (122) in eine Einbettungsschicht.

14. Verfahren (100) nach einem der vorangehenden Ansprüche,
wobei der Schritt des Einbettens (104) des Chip-Folien-Moduls (120) in die Leiterplatte (142) aufweist:
Bereitstellen zumindest einer Laminatebene der Leiterplatte (142),
Anordnen des Chip-Folien-Moduls (120) auf der zumindest einen Laminatebene der Leiterplatte (142) oder innerhalb der zumindest einen Laminatebene der Leiterplatte (142),
Bereitstellen zumindest einer weiteren Laminatebene der Leiterplatte (142) auf und/oder unter der zumindest einen Laminatebene der Leiterplatte (142), so dass das Chip-Folien-Modul (120) in der Leiterplatte (142) eingebettet ist.

15. Verfahren (100) nach einem der Ansprüche 1 bis 14,
wobei das Foliensubstrat (124) zumindest zwei von dem Halbleiterchip (122) beabstandetes Kopplungselemente (126_1,126_2) aufweist, die über zwei in oder auf dem Foliensubstrat (124) gebildete Leiterbahnen (130_1,130_2) mit zumindest zwei Anschlüssen (128_1,128_2) des Halbleiterchips (122) verbunden sind,
wobei die zumindest zwei Kopplungselemente (126_1,126_2) elektrische Anschlüsse sind,
wobei Leiterbahnen der Leiterplatte (142) über zumindest zwei Durchkontaktierungen als Gegenkopplungselemente (144_1,144_2) mit den Anschlüssen des Foliensubstrats (124) verbunden sind.

16. Verfahren (100) nach Anspruch 15,
wobei der Halbleiterchip (122) in dem Chip-Folien-Modul (120) in einer Einbettungsschicht (132), die auf dem Foliensubstrat (124) angeordnet ist, eingebettet ist.

17. Verfahren (100) nach Anspruch 16,
wobei sich die zumindest zwei Durchkontaktierungen vertikal durch das Foliensubstrat (124) oder durch die Einbettungsschicht (132) hindurch bis zu den zumindest zwei Anschlüssen des Foliensubstrats (124) erstrecken.

18. Verfahren (100) nach Anspruch 16,
wobei sich eine erste Durchkontaktierung der zumindest zwei Durchkontaktierungen ausgehend von einer ersten Ebene der Leiterplatte (142) vertikal durch das Foliensubstrat (124) hindurch bis zu einem ersten Anschluss (125_1) der zumindest zwei Anschlüsse (125_1,125_2) des Foliensubstrats (124) erstreckt,
und/oder wobei sich eine zweite Durchkontaktierung der zumindest zwei Durchkontaktierungen ausgehend von einer zweiten Ebene der Leiterplatte (142) vertikal durch die Einbettungsschicht des Chip-Folien-Moduls (120) hindurch bis zu einem zweiten Anschluss (125_2) der zumindest zwei Anschlüsse (125_1,125_2) des Foliensubstrats (124) erstreckt.

19. Verfahren (100) nach einem der Ansprüche 1 bis 14,
wobei das zumindest eine Kopplungselement (126; 126_1,126_2) auf oder in dem Foliensubstrat (124) angeordnet ist und über zumindest eine auf oder in dem Foliensubstrat (124) gebildete Leiterbahn (130_1) mit dem zumindest einen Anschluss (128; 128_1,128_2) des Halbleiterchips (122) verbunden ist.
wobei zumindest ein Kopplungselement (126_1) des zumindest einen Kopplungselements (126; 126_1,126_2) des Foliensubstrats (124) ein optisches Kopplungselement ist, wobei zumindest ein Kopplungsgegenelement (144_1) des zumindest einen Kopplungsgegenelements (144; 144_1,144_2) der Leiterplatte (142) ein optisches Kopplungsgegenelement ist, wobei das optische Kopplungselement und das optische Kopplungsgegenelement in vertikaler Richtung miteinander optisch gekoppelt sind.

20. Verfahren (100) nach Anspruch 19,
wobei zumindest ein weiteres Kopplungselement (126_2) des zumindest einen Kopplungselements (126; 126_1,126_2) auf oder in dem Foliensubstrat (124) angeordnet ist und über zumindest eine weitere auf oder in dem Foliensubstrat (124) gebildete Leiterbahn (130_2) mit zumindest einem weiteren Anschluss (128_2) des Halbleiterchips (122) verbunden ist,
wobei das zumindest eine weitere Kopplungselement (126_2) ein induktives oder kapazitives Kopplungselement ist, wobei zumindest ein weiteres Kopplungsgegenelement (144_2) des zumindest einen Kopplungsgegenelements (144; 144_1,144_2) der Leiterplatte (142) ein induktives oder kapazitives Kopplungsgegenelement ist, wobei das induktive oder kapazitive Kopplungselement (und das induktive oder kapazitive Kopplungsgegenelement in vertikaler Richtung miteinander induktiv oder kapazitiv gekoppelt sind.

21. Verfahren (100) nach einem der Ansprüche 1 bis 14,
wobei das Chip-Folien-Modul (120) zumindest zwei Kopplungselemente (126_1,126_2) aufweist,
wobei der Halbleiterchip (122) zumindest zwei Anschlüsse (128_2,128_2) aufweist,
wobei der Halbleiterchip (122) derart auf dem Foliensubstrat (124) angeordnet ist, dass die zumindest zwei Anschlüsse (128_2,128_2) des Halbleiterchips (122) dem Foliensubstrat (124) abgewandt sind,
wobei die zumindest zwei Kopplungselemente (126_1,126_2) in oder auf einer Einbettungsschicht (132) des Chip-Folien-Moduls (120) angeordnet sind, in der der Halbleiterchip (122) eingebettet ist,
wobei die zumindest zwei Kopplungselemente (126_1,126_2) über vertikale elektrische Verbindungen (131_1,131_2) mit dem zumindest zwei Anschlüssen des Halbleiterchips (122) verbunden sind,
wobei die zumindest zwei Kopplungselemente (126_1,126_2) elektrische Anschlüsse sind,
wobei Leiterbahnen der Leiterplatte (142) über zumindest zwei Durchkontaktierungen als Gegenkopplungselemente (144_1,144_2) mit den zumindest zwei Anschlüssen des Chip-Folien-Moduls (120) verbunden sind.

22. Verfahren (100) nach Anspruch 21,
wobei das Foliensubstrat (124) ein thermisch leitfähiges Foliensubstrat (124) ist,
wobei die Leiterplatte (142) benachbart zu dem thermisch leitfähigen Foliensubstrat (124) thermische Durchkontaktierung (137) aufweist, die ausgebildet sind, um thermische Energie von dem thermisch leitfähigen Foliensubstrat (124) an eine Umgebung der Leiterplatte (142) zu leiten.

23. Verfahren (100) nach einem der Ansprüche 1 bis 14,
wobei das Foliensubstrat (124) zumindest zwei Anschlusselemente (125_1,125_2) aufweist, die über zumindest zwei in auf der dem Foliensubstrat (124) gebildeten Leiterbahnen (130_1,130_2) mit zumindest zwei Anschlüssen (128_1,128_2) des Halbleiterchips (122) verbunden sind,
wobei das Chip-Folien-Modul (120) zumindest zwei übereinander liegende oder gestapelte Einbettungsschichten (132_1,132_2,...) aufweist, die den Halbleiterchip (122) und/oder das Foliensubstrat (124) einbetten,
wobei das Chip-Folien-Modul (120) zumindest zwei Kopplungselemente (126_1,126_2) aufweist, die in oder auf unterschiedlichen Einbettungsschichten der zumindest zwei Einbettungsschichten (132_1,132_2,...) angeordnet sind,
wobei die zumindest zwei Kopplungselemente (126_1,126_2) über vertikale elektrische Verbindungen (134_1,134_2) mit den zumindest zwei Anschlusselementen (125_1,125_2) des Foliensubstrats (124) verbunden sind,
wobei die zumindest zwei Kopplungselemente (126_1,126_2) elektrische Anschlüsse sind,
wobei Leiterbahnen der Leiterplatte (142) über zumindest zwei Durchkontaktierungen als Gegenkopplungselemente (144_1,144_2) mit den zumindest zwei Anschlüssen des Chip-Folien-Moduls (120) verbunden sind,
wobei sich eine erste Durchkontaktierung der zumindest zwei Durchkontaktierungen ausgehend von einer ersten Ebene der Leiterplatte (142) vertikal bis zu einem ersten Anschluss der zumindest zwei Anschlüsse des Chip-Folien-Moduls (120) erstreckt,
wobei sich eine zweite Durchkontaktierung der zumindest zwei Durchkontaktierungen ausgehend von einer zweiten Ebene der Leiterplatte (142) vertikal bis zu einem zweiten der zumindest zwei Anschlüsse des Foliensubstrats (124) erstreckt.

24. Verfahren (100) nach einem der vorangehenden Ansprüche,
wobei das Verfahren (100) einen Schritt des Bereitstellens eines weiteren Chip-Folien-Moduls (120) mit einem weiteren Halbleiterchip (122) und einem weiteren Foliensubstrat (124), auf dem der weitere Halbleiterchip (122) angeordnet ist, aufweist, wobei das weitere Chip-Folien-Modul (120) zumindest ein von dem weiteren Halbleiterchip (122) beabstandetes Kopplungselement (126; 126_1,126_2) aufweist, das mit zumindest einem Anschluss (128; 128_1,128_2) des weiteres Halbleiterchips (122) elektrisch gekoppelt ist, und
wobei das Verfahren (100) einen Schritt des Einbettens des weiteren Chip-Folien-Moduls (120) in die Leiterplatte (142) aufweist, wobei bei dem Einbetten des weiteren Chip-Folien-Moduls (120) in die Leiterplatte (142) das zumindest eine Kopplungselement (126; 126_1,126_2) des weiteren Chip-Folien-Moduls (120) vertikal mit zumindest einem weiteren Kopplungsgegenelement (144; 144_1,144_2) der Leiterplatte (142) gekoppelt wird,
wobei das Chip-Folien-Modul (120) und das weitere Chip-Folien-Modul (120) in vertikaler Richtung der Leiterplatte (142) gestapelt sind.

25. Verfahren (100) nach einem der vorangehenden Ansprüche,
wobei die Leiterplatte (142) zumindest zwei Leiterbahnebenen aufweist,
wobei das Chip-Folien-Modul (120) zwischen den zumindest zwei Leiterbahnebenen (149_1,149_2) angeordnet ist,
wobei bei dem Einbetten des Chip-Folien-Moduls (120) in die Leiterplatte (142) eine vertikale Durchkontaktierung durch das Chip-Folien-Modul (120) hindurch zum Verbinden von Leiterbahnen der zumindest zwei Leiterbahnebenen (149_1,149_2) gebildet wird.

26. Mikroelektronische Anordnung (140), mit folgenden Merkmalen:
einer Leiterplatte (142), und
einem Chip-Folien-Modul,
wobei das Chip-Folien-Modul (120) einen Halbleiterchip (122) und ein Foliensubstrat (124), auf dem der Halbleiterchip (122) angeordnet ist, aufweist,
wobei das Chip-Folien-Modul (120) zumindest ein von dem Halbleiterchip (122) beabstandetes Kopplungselement (126; 126_1,126_2) aufweist, das mit zumindest einem Anschluss (128; 128_1-128_2) des Halbleiterchips (122) elektrisch gekoppelt ist,
wobei das Chip-Folien-Modul (120) in die Leiterplatte (142) eingebettet ist,
wobei das zumindest eine Kopplungselement (126; 126_1,126_2) des Chip-Folien-Moduls (120) vertikal mit zumindest einem Kopplungsgegenelement (144; 144_1,144_2) der Leiterplatte (142) gekoppelt ist.

27. Chip-Folien-Modul (120), mit folgenden Merkmalen:
einem Foliensubstrat (124),
einem Halbleiterchip, der auf dem Foliensubstrat (124) angeordnet ist,
zumindest einem von dem Halbleiterchip (122) beabstandetes Kopplungselement, das auf oder in dem Foliensubstrat (124) angeordnet ist,
wobei das zumindest eine Kopplungselement (126; 126_1,126_2) über zumindest eine auf oder in dem Foliensubstrat (124) gebildeten Leiterbahn mit zumindest einem Anschluss (128; 128_1-128_2) des Halbleiterchips (122) elektrisch gekoppelt ist,
wobei das zumindest eine Kopplungselement (126; 126_1,126_2) konfiguriert ist, um mit zumindest einem externen Kopplungsgegenelement (144; 144_1,144_2) gekoppelt zu werden,
wobei das Chip-Folien-Modul (120) eine Einbettungsschicht aufweist, die auf dem Foliensubstrat (124) angeordnet ist, wobei die Einbettungsschicht den Halbleiterchip (122) und das zumindest eine Kopplungselement (126; 126_1,126_2) vollständig einbettet,
wobei das zumindest eine Kopplungselement (126; 126_1,126_2) ein elektrischer Anschluss ist.

28. Chip-Folien-Modul (120), mit folgenden Merkmalen:
einem Foliensubstrat (124),
einem Halbleiterchip, der auf dem Foliensubstrat (124) angeordnet ist,
zumindest einem von dem Halbleiterchip (122) beabstandetes Kopplungselement, das auf oder in dem Foliensubstrat (124) angeordnet ist,
wobei das zumindest eine Kopplungselement (126; 126_1,126_2) über zumindest eine auf oder in dem Foliensubstrat (124) gebildeten Leiterbahn mit zumindest einem Anschluss (128; 128_1-128_2) des Halbleiterchips (122) elektrisch gekoppelt ist,
wobei das zumindest eine Kopplungselement (126; 126_1,126_2) konfiguriert ist, um mit zumindest einem externen Kopplungsgegenelement (144; 144_1,144_2) gekoppelt zu werden,
wobei das Chip-Folien-Modul (120) eine Einbettungsschicht aufweist, die auf dem Foliensubstrat (124) angeordnet ist, wobei die Einbettungsschicht den Halbleiterchip (122) und das zumindest eine Kopplungselement (126; 126_1,126_2) vollständig einbettet,
wobei das zumindest eine Kopplungselement (126; 126_1,126_2) ein optisches Kopplungselement (126; 126_1,126_2) ist.

29. Chip-Folien-Modul (120), mit folgenden Merkmalen:
einem Foliensubstrat (124),
einem Halbleiterchip, der auf dem Foliensubstrat (124) angeordnet ist,
zumindest zwei von dem Halbleiterchip (122) beabstandete Kopplungselemente,
wobei das Foliensubstrat (124) zumindest zwei Anschlusselemente aufweist, die über zumindest zwei in auf der dem Foliensubstrat (124) gebildeten Leiterbahnen mit zumindest zwei Anschlüssen des Halbleiterchips (122) verbunden sind,
wobei das Chip-Folien-Modul (120) zumindest zwei übereinander liegende oder gestapelte Einbettungsschichten aufweist, die den Halbleiterchip (122) und/oder das Foliensubstrat (124) einbetten,
wobei die zumindest zwei Kopplungselemente in oder auf unterschiedlichen Einbettungsschichten der zumindest zwei Einbettungsschichten angeordnet sind,
wobei die zumindest zwei Kopplungselemente über vertikale elektrische Verbindungen mit den zumindest zwei Anschlusselementen des Foliensubstrats (124) verbunden sind,
wobei die zumindest zwei Kopplungselement (126; 126_1,126_2) konfiguriert sind, um mit zumindest zwei externen Gegenkopplungselementen gekoppelt zu werden.

30. Mikroelektronische Anordnung (140), mit folgenden Merkmalen:
einer Leiterplatte (142), und
einem Chip-Folien-Modul (120) nach einem der Ansprüche 27 bis 29,
wobei das Chip-Folien-Modul (120) in die Leiterplatte (142) eingebettet ist,
wobei das zumindest eine Kopplungselement (126; 126_1,126_2) des Chip-Folien-Moduls (120) vertikal mit zumindest einem Kopplungsgegenelement (144; 144_1,144_2) der Leiterplatte (142) gekoppelt ist.
